(19) Europäisches Patentamt
European Patent Office
Office européen des brevets

(11) **EP 3 309 561 B1**

(12) **EUROPÄISCHE PATENTSCHRIFT**

(45) Veröffentlichungstag und Bekanntmachung des Hinweises auf die Patenterteilung:
**02.01.2019  Patentblatt 2019/01**

(51) Int Cl.:
***G01R 23/02*** *(2006.01)*    ***G01R 23/00*** *(2006.01)*
***G01R 23/14*** *(2006.01)*

(21) Anmeldenummer: **17195650.1**

(22) Anmeldetag: **10.10.2017**

(54) **ELEKTRISCHES MESSSYSTEM UND BETRIEBSVERFAHREN HIERFÜR**

ELECTRICAL MEASUREMENT SYSTEM AND OPERATING METHOD

SYSTÈME DE MESURE ÉLECTRIQUE ET SON PROCÉDÉ DE FONCTIONNEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.10.2016  DE 102016119562**

(43) Veröffentlichungstag der Anmeldung:
**18.04.2018  Patentblatt 2018/16**

(73) Patentinhaber:
• **Horst Siedle GmbH & Co. KG.**
  **78120 Furtwangen (DE)**
• **Friedrich-Alexander-Universität Erlangen-Nürnberg**
  **91054 Erlangen (DE)**

(72) Erfinder:
• **LURZ, Fabian**
  **91052 Erlangen (DE)**
• **LINDNER, Stefan**
  **91052 Erlangen (DE)**
• **KÖLPIN, Alexander**
  **96120 Bischberg (DE)**
• **HALDER, Ernst**
  **70437 Stuttgart (DE)**
• **DINGLER, Peter**
  **73432 Aalen-Ebnat (DE)**
• **SEPT-ENZEL, Gerold**
  **70619 Stuttgart (DE)**

(74) Vertreter: **DREISS Patentanwälte PartG mbB**
  **Friedrichstraße 6**
  **70174 Stuttgart (DE)**

(56) Entgegenhaltungen:
**EP-A1- 1 067 675    DE-A1-102013 209 364**
**US-A- 5 170 126**

EP 3 309 561 B1

**Beschreibung**

Die Erfindung betrifft ein elektrisches Messsystem mit einer Sechs-Tor-Schaltung, einer Verzögerungsleitung, und einer Recheneinheit, wobei in einer ersten Betriebsart ein elektrisches Signal einerseits direkt an einen ersten Eingangsanschluss und andererseits über die Verzögerungsleitung an einen zweiten Eingangsanschluss der Sechs-Tor-Schaltung zuführbar ist, wobei die Recheneinheit dazu ausgebildet ist, eine Frequenz des Signals in Abhängigkeit wenigstens eines Ausgangssignals der Sechs-Tor-Schaltung zu ermitteln.

Die Erfindung betrifft ferner ein Betriebsverfahren für ein derartiges Messsystem.

Ein Messsystem der vorstehend genannten Art ist beispielsweise aus der DE 10 2013 209 364 A1 bekannt.

Es ist Aufgabe der vorliegenden Erfindung, die Präzision des bekannten Messsystems weiter zu steigern.

Diese Aufgabe wird bei dem Messsystem der eingangs genannten Art erfindungsgemäß dadurch gelöst, dass das Messsystem dazu ausgebildet ist, in einer zweiten Betriebsart dem ersten Eingangsanschluss der Sechs-Tor-Schaltung kein Signal, insbesondere kein eigenes (also von dem Messsystem bewusst erzeugtes) Signal, zuzuführen und dem zweiten Eingangsanschluss der Sechs-Tor-Schaltung ein vorgebbares Referenzsignal zuzuführen, wobei das Messsystem ferner dazu ausgebildet ist, in der zweiten Betriebsart in Abhängigkeit wenigstens eines Ausgangssignals der Sechs-Tor-Schaltung auf das Vorhandensein eines Störsignals, insbesondere im Bereich des ersten Eingangsanschlusses, zu schließen. Erfindungsgemäß ist erkannt worden, dass in der zweiten Betriebsart vorteilhaft auf das Vorhandensein wenigstens eines Störsignals im Bereich des Messsystems, insbesondere im Bereich des ersten Eingangsanschlusses, geschlossen werden kann, weil die Sechs-Tor-Schaltung bei Vorhandensein eines solchen Störsignals insbesondere im Frequenzbereich des Referenzsignals charakteristische Ausgangssignale ausgibt. Hierbei wird gleichsam das Störsignal als "Eingangssignal" für den ersten Eingangsanschluss der Sechs-Tor-Schaltung verwendet. In der zweiten Betriebsart wird daher dem ersten Eingangsanschluss kein Signal von dem elektrischen Messsystem oder einer darin enthaltenen Signalquelle zugeführt. Dadurch ist die Möglichkeit gegeben, dass ein gegebenenfalls vorhandenes Störsignal und vorzugsweise ausschließlich dieses Störsignal den ersten Eingangsanschluss der Sechs-Tor-Schaltung beaufschlagt, was unter gleichzeitiger Zuführung des Referenzsignals zu dem zweiten Eingangsanschluss der Sechs-Tor-Schaltung auf ein oder mehrere charakteristische Ausgangssignale der Sechs-Tor-Schaltung führt, die erfindungsgemäß vorteilhaft ausgewertet werden können.

Damit ist es möglich, gegebenenfalls vorhandene Störsignale zu erkennen, und einen Betrieb der erfindungsgemäßen Sechs-Tor-Schaltung hierauf einzustellen. Weiter wird hierdurch vorteilhaft eine störungsfreie Koexistenz mit anderen gleichartigen und/oder verschiedenartigen Systemen ermöglicht, weil andere Nutzer bzw. Systeme des gleichen Frequenzbands (wie es für das elektrische Signal verwendet wird) vorteilhaft weniger beeinflusst werden bzw. das erfindungsgemäße Messsystem weniger durch solche anderen Systeme störbar ist.

Beispielsweise kann bei einer Ausführungsform vorgesehen sein, zumindest für eine vorgebbare Wartezeit keine Messung der Frequenz des elektrischen Signals vorzunehmen, sofern in der zweiten Betriebsart das Vorhandensein eines Störsignals festgestellt worden ist.

Bei alternativen Ausführungsformen kann vorgesehen sein, dass eine Signalleistung des Störsignals ermittelt wird, und dass eine Entscheidung, ob trotz Vorhandensein des Störsignals eine Frequenzmessung des elektrischen Signals in der ersten Betriebsart ausgeführt werden soll, in Abhängigkeit der Signalleistung des Störsignals getroffen wird. Damit ist beispielsweise ermöglicht, bei verhältnismäßig kleinen Störsignalen dennoch eine erfindungsgemäße Frequenzmessung in der ersten Betriebsart auszuführen, wohingegen bei vergleichsweise starken Störsignalen die erste Betriebsart wie erwähnt zunächst nicht eingenommen wird.

Bei einer weiteren vorteilhaften Ausführungsform ist vorgesehen, dass die Recheneinheit dazu ausgebildet ist, in der zweiten Betriebsart wenigstens zwei an unterschiedlichen Ausgangsanschlüssen der Sechs-Tor-Schaltung erhaltene Ausgangssignale und/oder hiervon abgeleitete Signale auszuwerten und in Abhängigkeit der Auswertung auf ein Störsignal zu schließen. Dadurch ist eine besonders präzise Erkennung von Störsignalen möglich.

Die Recheneinheit kann einer Ausführungsform zufolge einen Mikrocontroller umfassen oder einen digitalen Signalprozessor oder dergleichen.

Bei den von den Ausgangssignalen der Sechs-Tor-Schaltung abgeleiteten Signalen kann es sich beispielsweise um gefilterte Versionen der Ausgangssignale handeln, welche beispielsweise einer Tiefpassfilterung unterzogen worden sind.

Bei einer weiteren vorteilhaften Ausführungsform ist vorgesehen, dass die Recheneinheit dazu ausgebildet ist, in der zweiten Betriebsart vier an unterschiedlichen Ausgangsanschlüssen der Sechs-Tor-Schaltung erhaltene Ausgangssignale und/oder hiervon abgeleitete Signale auszuwerten und in Abhängigkeit der Auswertung auf ein Störsignal zu schließen, wodurch eine weitere Steigerung der Präzision bzw. der Detektionssicherheit bezüglich der Erkennung eines Störsignals ermöglicht ist. Insbesondere kann bei der vorliegenden Ausführungsform eine Frequenz eines Störsignals genauer klassifiziert werden.

Bei einer weiteren vorteilhaften Ausführungsform ist vorgesehen, dass die Recheneinheit dazu ausgebildet ist, wenigstens zwei Ausgangssignale und/oder hiervon abgeleitete Signale im Wesentlichen gleichzeitig zu erfassen, was besonders präzise Messungen der Frequenz des elektrischen Signals ermöglicht.

Bei einer weiteren vorteilhaften Ausführungsform ist vorgesehen, dass das Messsystem dazu ausgebildet ist, die zweite Betriebsart anzunehmen, um das Vorhandensein von möglichen Störsignalen zu untersuchen, wodurch ein Störsignal charakterisierende Informationen erhalten werden, und wobei das Messsystem dazu ausgebildet ist, nach der zweiten Betriebsart in Abhängigkeit der ein Störsignal charakterisierenden Informationen in die erste Betriebsart zu wechseln, um eine Frequenz des elektrischen Signals zu ermitteln.

Bei einer weiteren vorteilhaften Ausführungsform ist vorgesehen, dass das Messsystem wenigstens einen Resonator aufweist, der dazu ausgebildet ist, das elektrische Signal bereitzustellen, wobei insbesondere der wenigstens eine Resonator als akustischer Oberflächenwellenresonator, kurz SAW-Resonator (SAW = surface acoustic wave), ausgebildet ist.

Kommt als Resonator ein SAW-Resonator zum Einsatz, so werden von diesem üblicherweise kurze und abklingende Antwortsignale abgegeben. Hier ist die vorgenannte Sechs-Tor-Technologie besonders gut dazu geeignet, diese Signale des SAW-Resonators auszuwerten.

Bei einer Weiterbildung der Erfindung entspricht die Frequenz des elektrischen Signals einer (momentanen) Resonanz-Frequenz des Resonators, die unter anderem abhängig sein kann von der Temperatur und/oder dem Druck und/oder der Dehnung, dem bzw. denen der Resonator ausgesetzt ist. Eine Änderung der Temperatur und/oder des Drucks und/oder der Dehnung des Resonators führt dann zu einer Änderung der Resonanz-Frequenz, was von der Sechs-Tor-Schaltung in der ersten Betriebsart ermittelt werden kann. Auf diese Weise kann die Sechs-Tor-Technologie beispielsweise zur Ermittlung einer Temperatur oder eines Drucks oder einer (mechanischen) Dehnung zum Einsatz kommen. Vorteilhaft kann damit beispielsweise eine mechanische Beanspruchung eines Maschinenelements, beispielsweise eine Torsion einer Welle, ermittelt werden.

Bei einer weiteren vorteilhaften Ausführungsform ist vorgesehen, dass das Messsystem wenigstens einen Signalgenerator aufweist, der dazu ausgebildet ist, das Referenzsignal und/oder ein Anregungssignal für einen bzw. den Resonator bereitzustellen. Mit Hilfe des Anregungssignals wird der Resonator mit Energie aufgeladen. Diese Energie kann dann der Resonator wieder abgeben, und zwar über das Antwortsignal mit der Resonanz-Frequenz. Bevorzugt liegt die Frequenz des Anregungssignals zumindest etwa im Bereich der Resonanz-Frequenz des Resonators, um diesen hinreichend anzuregen.

Bei einer vorteilhaften Ausführungsform weist der Signalgenerator beispielsweise einen Oszillator, insbesondere einen steuerbaren Oszillator, auf. Beispielsweise kann der Signalgenerator einer Ausführungsform zufolge einen spannungsgesteuerten Oszillator (VCO, voltage controlled oscillator) aufweisen. Eine Steuerung des Oszillators kann beispielsweise durch die Recheneinheit des erfindungsgemäßen Messsystems ausgeführt werden.

Bei einer weiteren vorteilhaften Ausführungsform weist der Signalgenerator einen Frequenzsynthesizer auf, bei dem dem Oszillator eine Phasenregelschleife (PLL, phase locked loop) zugeordnet ist, wodurch in an sich bekannter Weise ein besonders frequenzstabiles Signal zum Beispiel für eine Verwendung als Referenzsignal und/oder Anregungssignal erzeugbar ist.

Bei einer weiteren vorteilhaften Ausführungsform ist vorgesehen, dass das Messsystem eine Koppeleinrichtung aufweist, die dazu ausgebildet ist, ein Anregungssignal an wenigstens einen Resonator auszugeben und ein Ausgangssignal des wenigstens einen Resonators zu empfangen und an wenigstens einen Eingang der Sechs-Tor-Schaltung und/oder an einen der Sechs-Tor-Schaltung zugeordneten Leistungsteiler auszugeben. Damit ist eine besonders effiziente Versorgung des Resonators und der Sechs-Tor-Schaltung mit den betreffenden Signalen ermöglicht. Das Anregungssignal kann wie vorstehend bereits beschrieben weiteren Ausführungsformen zufolge beispielsweise durch den Signalgenerator erzeugt werden. Der Leistungsteiler kann beispielsweise dazu vorgesehen sein, das Ausgangssignal des Resonators bzw. einen entsprechenden ersten Teil hiervon, beispielsweise 50% der Signalleistung, als der Frequenzmessung zugrunde zu legendes elektrisches Signal dem ersten Eingangsanschluss der Sechs-Tor-Schaltung zuzuführen, wobei ein zweiter Teil des Ausgangssignals, beispielsweise bei weiteren 50 % der Signalleistung, einem Eingang der Verzögerungsleitung zugeführt wird. Bei einer bevorzugten Ausführungsform kann der Leistungsteiler beispielsweise wenigstens einen Wilkinson-Teiler umfassen.

Bei einer bevorzugten Ausführungsform kann die Koppeleinrichtung beispielsweise wenigstens einen Zirkulator oder Richtkoppler aufweisen. Alternativ hierzu kann bei einer weiteren Ausführungsform die Koppeleinrichtung wenigstens einen Sende-Empfangsschalter (englisch: RX/TX-switch) umfassen.

Bei weiteren vorteilhaften Ausführungsformen können auch mehrere Schalter (z.B. mit drei Anschlüssen ("Ports")) vorgesehen sein, beispielsweise um zwischen einer ersten Schalterstellung zur Eigenlinearisierung, einer zweiten Schalterstellung zum Senden zum Beispiel eines Anregungssignals und einer dritten Schalterstellung zum Empfangen zum Beispiel eines Antwortsignals auf ein Anregungssignal umzuschalten.

Bei einer weiteren vorteilhaften Ausführungsform ist vorgesehen, dass das Messsystem einen ersten Schalter aufweist, der dazu ausgebildet ist, ein an seinem Eingang zugeführtes Eingangssignal wahlweise an einem ersten Ausgangsanschluss seines Ausgangs oder an einem zweiten Ausgangsanschluss seines Ausgangs auszugeben, wobei insbesondere der Eingang des ersten Schalters mit einem bzw. dem Signalgenerator verbindbar ist, wobei der erste Ausgangsanschluss des ersten Schalters mit einer bzw. der Koppeleinrichtung verbindbar ist, wobei der zweite Ausgangsanschluss des ersten Schalters mit wenigstens einem Eingang der Sechs-Tor-Schaltung und/oder einem Eingang eines der Sechs-Tor-Schaltung zugeordneten Leistungsteilers verbindbar ist.

Bei einer weiteren vorteilhaften Ausführungsform ist vorgesehen, dass das Messsystem einen zweiten Schalter aufweist, der dazu ausgebildet ist, den zweiten Eingang der Sechs-Tor-Schaltung wahlweise mit einer ein bzw. das Referenzsignal bereitstellenden Quelle oder einem Ausgang der Verzögerungsleitung zu verbinden. Auf diese Weise kann der Sechs-Tor-Schaltung vorteilhaft das für die jeweilige erste oder zweite Betriebsart erforderliche Signal für den zweiten Eingangsanschluss effizient bereitgestellt werden.

Bei einer weiteren vorteilhaften Ausführungsform ist vorgesehen, dass die Verzögerungsleitung wenigstens zwei wahlweise einstellbare Verzögerungsleitungslängen aufweist. Dadurch kann die Präzision bei der Frequenzmessung vorteilhaft weiter gesteigert und insbesondere auch eine eindeutige Detektionsbandbreite erhöht werden. Hierdurch wird vorteilhaft eine störungsfreie Koexistenz mit anderen gleichartigen und/oder verschiedenartigen Systemen weiter verbessert.

Bei einer weiteren vorteilhaften Ausführungsform ist vorgesehen, dass das Messsystem dazu ausgebildet ist, in einer dritten Betriebsart eine erste Verzögerungsleitungslänge der Verzögerungsleitung einzustellen, und in einer vierten Betriebsart eine zweite Verzögerungsleitungslänge der Verzögerungsleitung einzustellen, wobei die zweite Verzögerungsleitungslänge verschieden ist von der ersten Verzögerungsleitungslänge, wobei insbesondere die zweite Verzögerungsleitungslänge größer ist als die erste Verzögerungsleitungslänge. Besonders vorteilhaft ermöglicht eine Frequenzmessung des elektrischen Signals unter Verwendung der zweiten Verzögerungsleitungslänge eine erhöhte Messgenauigkeit, während mit einer ersten, kleineren, Verzögerungsleitungslänge vorteilhaft ein vergleichsweise großer Eindeutigkeitsbereich für die Frequenzmessung geschaffen wird.

Besonders bevorzugt ist die erste Verzögerungsleitungslänge einer weiteren Ausführungsform zufolge so ausgebildet, dass der Eindeutigkeitsbereich für die Frequenzmessung in der ersten Betriebsart des erfindungsgemäßen Messsystems den kompletten Frequenzbereich eines ISM Bands umfasst, insbesondere einen Frequenzbereich zwischen etwa 2400 Megahertz, MHz, und etwa 2500 MHz.

Bei einer weiteren vorteilhaften Ausführungsform ist vorgesehen, dass das Messsystem dazu ausgebildet ist, zumindest zeitweise ein Linearisierungssignal einerseits direkt dem ersten Eingangsanschluss der Sechs-Tor-Schaltung und andererseits über die Verzögerungsleitung dem zweiten Eingangsanschluss der Sechs-Tor-Schaltung zuzuführen. Das Linearisierungssignal kann ähnlich wie das elektrische Signal bzw. das Anregungssignal bzw. das Referenzsignal beispielsweise ein Sinus-förmiges Signal sein, wobei das Linearisierungssignal zusätzlich eine bekannte Frequenz und Amplitude aufweist. Damit ist vorteilhaft die Möglichkeit der Linearisierung des Messsystems, insbesondere der Kalibrierung der Verzögerungsleitung, gegeben.

Als eine weitere Lösung der Aufgabe der vorliegenden Erfindung ist ein Verfahren zum Betreiben eines elektrischen Messsystems mit einer Sechs-Tor-Schaltung, einer Verzögerungsleitung, und einer Recheneinheit angegeben, wobei in einer ersten Betriebsart ein elektrisches Signal einerseits direkt an einen ersten Eingangsanschluss und andererseits über die Verzögerungsleitung an einen zweiten Eingangsanschluss der Sechs-Tor-Schaltung zugeführt wird, und wobei die Recheneinheit eine Frequenz des Signals in Abhängigkeit wenigstens eines Ausgangssignals der Sechs-Tor-Schaltung ermittelt, wobei das Messsystem in einer zweiten Betriebsart dem ersten Eingangsanschluss der Sechs-Tor-Schaltung kein Signal zuführt und dem zweiten Eingangsanschluss der Sechs-Tor-Schaltung ein vorgebbares Referenzsignal zuführt, wobei das Messsystem ferner in der zweiten Betriebsart in Abhängigkeit wenigstens eines Ausgangssignals der Sechs-Tor-Schaltung auf das Vorhandensein eines Störsignals, insbesondere im Bereich des ersten Eingangsanschlusses, schließt.

Bei einer vorteilhaften Ausführungsform ist vorgesehen, dass die Recheneinheit in der zweiten Betriebsart wenigstens zwei an unterschiedlichen Ausgangsanschlüssen der Sechs-Tor-Schaltung erhaltene Ausgangssignale und/oder hiervon abgeleitete Signale auswertet und in Abhängigkeit der Auswertung auf ein Störsignal schließt, wobei die Recheneinheit insbesondere in der zweiten Betriebsart vier an unterschiedlichen Ausgangsanschlüssen der Sechs-Tor-Schaltung erhaltene Ausgangssignale und/oder hiervon abgeleitete Signale auswertet und in Abhängigkeit der Auswertung auf ein Störsignal schließt.

Bei einer weiteren vorteilhaften Ausführungsform ist vorgesehen, dass die Recheneinheit wenigstens zwei Ausgangssignale und/oder hiervon abgeleitete Signale im Wesentlichen gleichzeitig erfasst.

Bei einer weiteren vorteilhaften Ausführungsform ist vorgesehen, dass das Messsystem die zweite Betriebsart annimmt, um das Vorhandensein von möglichen Störsignalen zu untersuchen, wodurch ein Störsignal charakterisierende Informationen erhalten werden, wobei das Messsystem nach der zweiten Betriebsart in Abhängigkeit der ein Störsignal charakterisierenden Informationen in die erste Betriebsart wechselt (beispielsweise nach einer vorgebbaren Wartezeit, die in Abhängigkeit der das Störsignal charakterisierenden Informationen gebildet werden kann, oder gar nicht, falls beispielsweise das Störsignal zu stark ist), um eine Frequenz des elektrischen Signals zu ermitteln.

Bei einer weiteren vorteilhaften Ausführungsform ist vorgesehen, dass das Messsystem in Abhängigkeit der ein Störsignal charakterisierenden Informationen eine Wartezeit ermittelt, für die gewartet wird, bevor ein Wechsel von der zweiten Betriebsart in die erste Betriebsart erfolgt.

Bei einer weiteren vorteilhaften Ausführungsform ist vorgesehen, dass das Messsystem wenigstens einen Signalgenerator aufweist, und mittels des Signalgenerators ein bzw. das Referenzsignal und/oder ein Anregungssignal für einen Resonator bereitstellt. Wie bereits vorstehend erwähnt, kann bei manchen Ausführungsformen der Signalgenerator einen Oszillator und/oder einen steuerbaren Oszillator (z.B. VCO) und/oder einen Oszillator mit Phasenregelschleife aufweisen.

Bei einer weiteren vorteilhaften Ausführungsform ist vorgesehen, dass das Messsystem eine Koppeleinrichtung aufweist, wobei das Messsystem ein Anregungssignal mittels der Koppeleinrichtung an wenigstens einen Resonator ausgibt und ein Ausgangssignal des wenigstens einen Resonators empfängt und an wenigstens einen Eingang der Sechs-Tor-Schaltung und/oder an einen der Sechs-Tor-Schaltung zugeordneten Leistungsteiler ausgibt.

Bei einer weiteren vorteilhaften Ausführungsform ist vorgesehen, dass das Messsystem einen ersten Schalter aufweist, wobei das Messsystem mittels des ersten Schalters ein an seinem Eingang zugeführtes Eingangssignal, insbesondere ein Referenzsignal oder ein Anregungssignal für einen Resonator, wahlweise an eine bzw. die Koppeleinrichtung ausgibt oder an einen Eingang der Sechs-Tor-Schaltung und/oder an einen Eingang eines der Sechs-Tor-Schaltung zugeordneten Leistungsteilers.

Bei einer weiteren vorteilhaften Ausführungsform ist vorgesehen, dass das Messsystem einen zweiten Schalter aufweist, wobei das Messsystem mittels des zweiten Schalters den zweiten Eingang der Sechs-Tor-Schaltung wahlweise mit einer ein bzw. das Referenzsignal bereitstellenden Quelle oder einem Ausgang der Verzögerungsleitung verbindet.

Bei einer weiteren vorteilhaften Ausführungsform ist vorgesehen, dass die Verzögerungsleitung wenigstens zwei wahlweise einstellbare Verzögerungsleitungslängen aufweist, und wobei das Messsystem in einer dritten Betriebsart eine erste Verzögerungsleitungslänge der Verzögerungsleitung einstellt, und in einer vierten Betriebsart eine zweite Verzögerungsleitungslänge der Verzögerungsleitung einstellt, wobei die zweite Verzögerungsleitungslänge verschieden ist von der ersten Verzögerungsleitungslänge, wobei insbesondere die zweite Verzögerungsleitungslänge größer ist als die erste Verzögerungsleitungslänge.

Bei einer weiteren vorteilhaften Ausführungsform ist vorgesehen, dass das elektrische Signal bzw. das Anregungssignal und/oder das Referenzsignal in wenigstens einem ISM (industrial, scientific, medical) - Frequenzband liegt, besondere in einem Frequenzbereich zwischen etwa 2400 MHz und etwa 2500 MHz.

Bei einer weiteren vorteilhaften Ausführungsform ist vorgesehen, dass das Messsystem zumindest zeitweise wenigstens einen Datenrahmen, insbesondere einen beacon-Datenrahmen gemäß der IEEE 802.11 Protokollfamilie (und/oder gemäß wenigstens einer der folgenden Protokolle: IEEE 802.15.4, insbesondere Zig-Bee und/oder Bluetooth), aussendet, insbesondere um anderen gegebenenfalls in Funkreichweite befindlichen Systemen das Vorhandensein eines Senders zu suggerieren, der insbesondere gemäß der IEEE 802.11 Protokollfamilie und/oder gemäß wenigstens einer der folgenden Protokolle arbeitet: IEEE 802.15.4, insbesondere ZigBee und/oder Bluetooth, arbeitet. Dadurch kann vorteilhaft erreicht werden, dass andere Systeme (z.B. WLAN, wireless local area network, router, ZigBee, Bluetooth, andere WPAN oder PAN Systeme), welche den beacon-Datenrahmen des erfindungsgemäßen Messsystems auswerten, darauf schließen, dass der von dem Messsystem für die Aussendung des beacon-Datenrahmens verwendete Kommunikations- bzw. Funkkanal besetzt ist, was diese anderen Systeme gegebenenfalls dazu veranlassen kann, fortan den betreffenden Funkkanal nicht mehr zu benutzen, wodurch sich eine geringere Beaufschlagung des von dem erfindungsgemäßen Messsystem verwendeten Frequenzbereichs durch Störsignale ergibt.

Bei einer weiteren vorteilhaften Ausführungsform ist vorgesehen, dass das Messsystem dann wenigstens einen Datenrahmen, insbesondere beacon-Datenrahmen gemäß der IEEE 802.11 Protokollfamilie aussendet, wenn zuvor in der zweiten Betriebsart festgestellt worden ist, dass ein Störsignal mit einer einen Schwellwert überschreitenden Signalleistung vorliegt.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in den Figuren.

In der Zeichnung zeigt:

Figur 1     schematisch ein Blockdiagramm einer ersten Ausführungsform des erfindungsgemäßen Messsystems in einer ersten Betriebsart,

Figur 2     schematisch ein Blockdiagramm des Messsystems gemäß Figur 1 in einer zweiten Betriebsart,

Figur 3 schematisch ein Blockdiagramm einer zweiten Ausführungsform des erfindungsgemäßen Messsystems,

Figur 4 schematisch ein Blockdiagramm einer dritten Ausführungsform des erfindungsgemäßen Messsystems,

Figur 5 schematisch ein Blockdiagramm einer vierten Ausführungsform des erfindungsgemäßen Messsystems,

Figur 6A ein vereinfachtes Flussdiagramm einer Ausführungsform des erfindungsgemäßen Verfahrens,

Figur 6B ein vereinfachtes Flussdiagramm einer zweiten Ausführungsform des erfindungsgemäßen Verfahrens,

Figur 6C ein vereinfachtes Flussdiagramm einer dritten Ausführungsform des erfindungsgemäßen Verfahrens,

Figur 7 ein vereinfachtes Blockdiagramm einer Ausführungsform einer erfindungsgemäßen Koppeleinrichtung, und

Figur 8 schematisch ein vereinfachtes Blockdiagramm einer weiteren Ausführungsform der Erfindung.

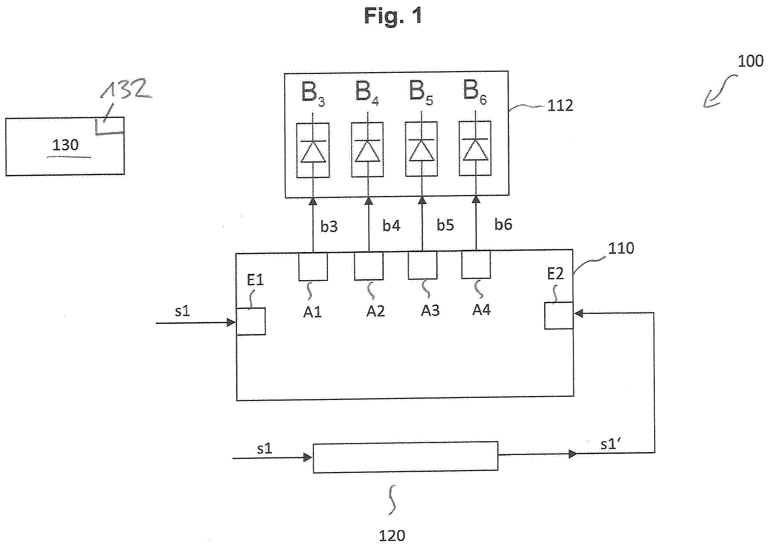

Figur 1 zeigt schematisch ein Blockdiagramm einer ersten Ausführungsform des erfindungsgemäßen Messsystems 100 in einer ersten Betriebsart.

Das Messsystem 100 weist eine Sechs-Tor-Schaltung 110 auf, eine Verzögerungsleitung 120, und eine Recheneinheit 130. Die Sechs-Tor-Schaltung 110 weist einen ersten Eingangsanschluss E1 auf und einen zweiten Eingangsanschluss E2, über die der Sechs-Tor-Schaltung 110 in an sich bekannter Weise Eingangssignale zuführbar sind. Vorliegend ist das Messsystem 100 dazu ausgebildet, in einer ersten Betriebsart ein elektrisches Signal s1 einerseits direkt dem ersten Eingangsanschluss E1 der Sechs-Tor-Schaltung 110 und andererseits das elektrische Signal s1 über die Verzögerungsleitung 120 dem zweiten Eingangsanschluss E2 der Sechs-Tor-Schaltung 110 zuzuführen.

Die Verzögerungsleitung 120 verzögert in an sich bekannter Weise (Prinzip der Laufzeitleitung) das ihr zugeführte elektrische Signal s1, sodass an ihrem Ausgang eine hierzu verzögerte Variante s1' erhalten wird. Die verzögerte Variante s1' weist eine entsprechende Phasenverschiebung d_phi gegenüber dem elektrischen Signal s1 auf, wie es dem ersten Eingangsanschluss E1 zugeführt wird.

Die Phasenverschiebung d_phi hängt von der Frequenz des elektrischen Signals s1 gemäß der folgenden Gleichung ab: d_phi = 2 * Pi * f * t_dl, wobei "*" der Multiplikationsoperator ist, wobei Pi die Kreiszahl (3,141...) ist, wobei f die Frequenz des elektrischen Signals s1 ist, wobei t_dl die Verzögerungszeit ist, welcher das elektrische Signal s1 bei Durchlaufen der Verzögerungsleitung 120 unterworfen wird.

Die Sechs-Tor-Schaltung 110 ist dazu ausgebildet, diese durch die Verzögerungsleitung 120 verursachte Phasenverschiebung zwischen den Signalen s1, s1' auszuwerten. Hierzu kann die Sechs-Tor-Schaltung 110 beispielsweise die beiden Eingangssignale s1, s1' unter vier verschiedenen Phasenverschiebungen von 0°, 90°, 180°, 270° einander überlagern, wodurch insgesamt vier Ausgangssignale b3, b4, b5, b6 erhalten werden.

Besonders bevorzugt kann die Sechs-Tor-Schaltung 110 auch dazu ausgebildet sein, die vier Ausgangssignale b3, b4, b5, b6 einer Frequenzabwärtsumsetzung (englisch: downconversion) zu unterziehen, was vorliegend in Figur 1 durch die nicht näher bezeichneten Diodensymbole des Blocks 112 angedeutet ist. Dementsprechend werden vier weitere Ausgangssignale $B_3$, $B_4$, $B_5$, $B_6$, welche jeweils Basisbandsignale sind, am Ausgang des Blocks 112 erhalten. Die vier weitere Ausgangssignale $B_3$, $B_4$, $B_5$, $B_6$, die beispielsweise jeweils in Form einer entsprechenden elektrischen Spannung vorliegen, bilden einen komplexen Ausgangsvektor $Z = (B_5-B_6) + j (B_3-B_4)$ aus dessen Phase in an sich bekannter Weise die vorstehend genannte Phasenverschiebung d_phi ermitteln lässt, vgl. die folgende Gleichung: $d\_phi = \tan^{-1}((B_3-B_4)/(B_5-B_6))$, wobei $\tan^{-1}()$ die inverse Tangensfunktion (Arcustangens) ist. Sofern die Verzögerungszeit t_dl bekannt ist, kann daher die Frequenz des elektrischen Signals s1 wie folgt ermittelt werden:

$$f = (d\_phi) / (2*Pi*t\_dl).$$

Die vorstehend genannten Berechnungen können bei einer Ausführungsform des erfindungsgemäßen Verfahrens vorteilhaft durch die Recheneinheit 130 unter Verwendung der Sechs-Tor-Schaltung 110 bzw. des Blocks 112 ausgeführt werden. Erfindungsgemäß erfolgen diese Berechnungen für die Messung der Frequenz f in einer ersten Betriebsart des Messsystems 100. Dieser Zustand ist in Figur 1 abgebildet.

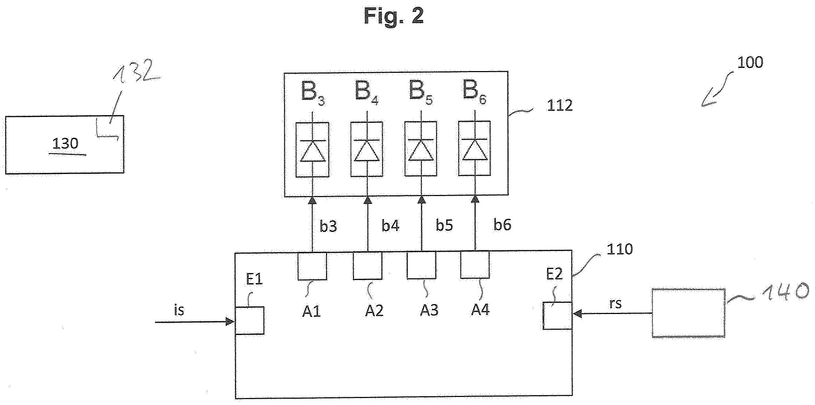

Erfindungsgemäß ist mindestens eine zweite Betriebsart für das Messsystem 100 vorgesehen. Ein der zweiten Betriebsart entsprechender Betriebszustand ist in Figur 2 abgebildet. Im Unterschied zu der in Figur 1 abgebildeten Konfiguration wird in der zweiten Betriebsart, vergleiche Figur 2, nunmehr dem ersten Eingangsanschluss E1 kein Eingangssignal zugeführt, so das allenfalls im Bereich des Messsystems 100 bzw. insbesondere im Bereich des ersten Eingangsanschlusses E1 vorliegende Störsignale is an dem ersten Eingangsanschluss E1 anliegen. Ferner ist das Messsystem 100 dazu ausgebildet, in der zweiten Betriebsart dem zweiten Eingangsanschluss E2 der Sechs-Tor-Schaltung 110 ein vorgebbares Referenzsignal rs zuzuführen. Dies wird vorliegend mittels eines Signalgenerators 140 bewerkstelligt, der beispielsweise ein Sinus-förmiges Ausgangssignal vorgebbarer Frequenz und Amplitude an den zweiten Eingangsanschluss E2 der Sechs-Tor-Schaltung ausgibt.

Bei bevorzugten Ausführungsformen kann der Signalgenerator 140 ferner dazu ausgebildet sein, Ausgangssignale, insbesondere Sinus-förmige Ausgangssignale, unterschiedlicher bzw. veränderlicher Frequenz auszugeben.

Erfindungsgemäß ist das Messsystem 100 dazu ausgebildet, in der zweiten Betriebsart in Abhängigkeit wenigstens eines Ausgangssignals b3, b4, b5, b6 der Sechs-Tor-Schaltung 110 auf das Vorhandensein eines bzw. des Störsignals is, insbesondere im Bereich des ersten Eingangsanschlusses E1, zu schließen.

Dadurch kann vorteilhaft festgestellt werden, ob im Bereich des Messsystems 100 bzw. im Bereich des ersten Eingangsanschlusses E1 ein Störsignal is vorliegt, dass die während der ersten Betriebsart auszuführende Messung bzw. Ermittlung der Frequenz des elektrischen Signals s1 möglicherweise stören könnte.

Bei einer bevorzugten Ausführungsform ist vorgesehen, dass die Recheneinheit 130 dazu ausgebildet ist, in der zweiten Betriebsart wenigstens zwei an unterschiedlichen Ausgangsanschlüssen A1, A2 der Sechs-Tor-Schaltung 110 erhaltene Ausgangssignale b3, b4 und/oder hiervon abgeleitete Signale $B_3$, $B_4$ auszuwerten und in Abhängigkeit der Auswertung auf das Störsignal is (und beispielsweise auf seine Leistung und/oder Frequenz) zu schließen.

Besonders bevorzugt ist die Recheneinheit 130 dazu ausgebildet, in der zweiten Betriebsart vier an unterschiedlichen Ausgangsanschlüssen A1, A2, A3, A4 der Sechs-Tor-Schaltung 110 erhaltene Ausgangssignale b3, b4, b5, b6, also alle Ausgangssignale, und/oder hiervon abgeleitete Signale $B_3$, $B_4$, $B_5$, $B_6$ auszuwerten und in Abhängigkeit der Auswertung auf ein Störsignal is zu schließen, wodurch sich eine gegenüber der Auswertung von weniger als vier Ausgangssignalen gesteigerte Präzision bzw. Detektionssicherheit ergibt.

Bei einer Ausführungsform kann die Recheneinheit 130 beispielsweise einen Betrag der Ausgangssignale b3, b4, b5, b6, und/oder der hiervon abgeleitete Signale $B_3$, $B_4$, $B_5$, $B_6$ auswerten, um auf das Vorhandensein bzw. eine Leistung und/oder eine Frequenz eines Störsignals is zu schließen bzw. diese zu ermitteln.

Bei einer bevorzugten Ausführungsform kann die Recheneinheit 130 hierfür über einen Analog/Digital-Umsetzer 132 verfügen, der bevorzugt dazu ausgebildet ist, wenigstens zwei Ausgangssignale b3, b4 und/oder hiervon abgeleitete Signale $B_3$, $B_4$ im Wesentlichen gleichzeitig zu erfassen. Im Wesentlichen gleichzeitig bedeutet vorliegend insbesondere, dass die betreffenden Signale zu unterschiedlichen Abtastzeitpunkten erfasst werden können, welche zeitlich maximal etwa 100 ns (Nanosekunden) auseinanderliegen, besonders bevorzugt maximal etwa 10 ns.

Bei einer bevorzugten Ausführungsform ist das Messsystem 100 dazu ausgebildet, die zweite Betriebsart anzunehmen, um das Vorhandensein von möglichen Störsignalen is zu untersuchen, wodurch ein Störsignal charakterisierende Informationen erhalten werden, wobei das Messsystem 100 ferner dazu ausgebildet ist, nach der zweiten Betriebsart in Abhängigkeit der ein Störsignal charakterisierenden Informationen in die erste Betriebsart zu wechseln, um eine Frequenz des elektrischen Signals s1 zu ermitteln.

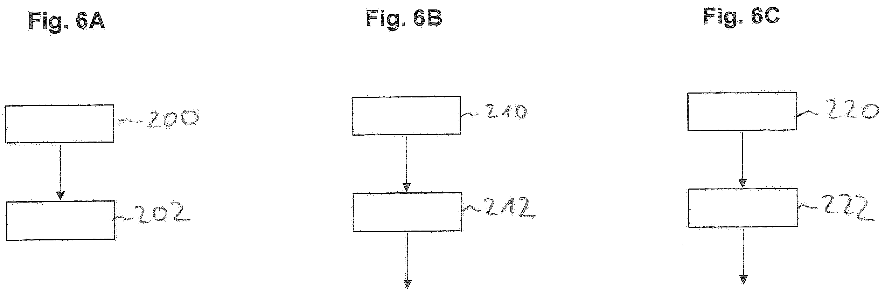

Figur 6A zeigt hierzu beispielhaft ein vereinfachtes Flussdiagramm einer Ausführungsform des erfindungsgemäßen Verfahrens. In Schritt 200 nimmt das Messsystem 100 (Figur 1, 2) die erfindungsgemäße zweite Betriebsart ein, um festzustellen, ob ein Störsignal is im Bereich des Messsystems 100 bzw. insbesondere seines ersten Eingangsanschlusses E1 vorliegt. In diesem Schritt 200 wird dem ersten Eingangsanschluss E1 daher durch die Recheneinheit 130 bzw. generell das Messsystem 100 aktiv kein Eingangssignal zugeführt, sodass allenfalls vorhandene Störsignale is in den Eingangsanschluss E1 einkoppeln können. In Schritt 200 wird ferner gemäß Figur 2 dem zweiten Eingangsanschluss E2 ein Referenzsignal rs vorgebbarer Frequenz und/oder Amplitude durch den Signalgenerator 140 zugeführt. Beispielsweise kann das Referenzsignal in einem ISM-Frequenzband liegen, beispielsweise im Bereich von etwa 2400 MHz bis etwa 2500 MHz. Das erfindungsgemäße Messsystem 100 ermittelt nun in Schritt 200, ob ein Störsignal is vorliegt, und gegebenenfalls welche Signalleistung bzw. sonstigen Eigenschaften es aufweist.

Sofern beispielsweise die Signalleistung des Störsignals is einen vorgebbaren Schwellwert unterschreitet bzw. gar kein Störsignal is vorliegt, wechselt das erfindungsgemäße Messsystem 100 eine erste Betriebsart, die durch den weiteren Schritt 202, vergleiche Figur 6A, repräsentiert ist. In der ersten Betriebsart bzw. in Schritt 202 führt das erfindungsgemäße Messsystem 100 in an sich bekannter Weise eine Messung der Frequenz des elektrischen Signals s1 aus, vergleiche Figur 1 und die vorangehende Beschreibung hierzu.

Durch den erfindungsgemäßen Schritt 200 ist vorteilhaft sichergestellt, dass eine Frequenzmessung gemäß Schritt 202 beispielsweise nur dann ausgeführt wird, wenn keine signifikanten Störsignale vorliegen, sodass sichergestellt ist, dass die Frequenzmessung besonders präzise erfolgen kann.

Bei einer weiteren bevorzugten Ausführungsform weist das Messsystem 100 (Fig. 1) wenigstens einen Resonator auf, der dazu ausgebildet ist, das elektrische Signal bereitzustellen, wobei insbesondere der wenigstens eine Resonator als akustischer Oberflächenwellenresonator ausgebildet ist.

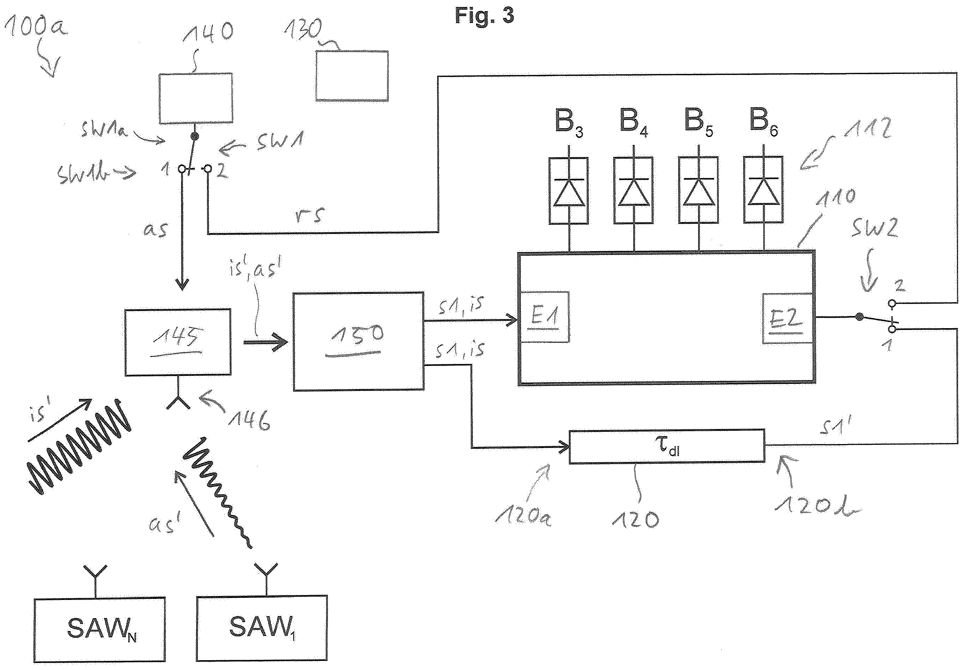

Figur 3 zeigt hierzu schematisch ein Blockdiagramm einer zweiten Ausführungsform 100a des erfindungsgemäßen Messsystems. Das Messsystem 100a weist eine Sechs-Tor-Schaltung 110 auf, wie sie bereits vorstehend unter Bezugnahme auf die Ausführungsform gemäß Figur 1, 2 beschrieben worden ist. Ebenso weist das Messsystem 100a der Figur 3 eine Laufzeitleitung 120 auf, wie sie bereits vorstehend unter Bezugnahme auf die Ausführungsform gemäß Figur 1, 2 beschrieben worden ist. Ferner weist das Messsystem 100a eine Recheneinheit 130 auf, die einen Betrieb des Messsystems 100a in der nachstehend näher beschriebenen Weise steuert.

Zusätzlich zu den Komponenten 110, 112, 120, 130 weist das Messsystem 100a einen Signalgenerator 140 auf, der bevorzugt als Frequenzsynthesizer für Hochfrequenzsignale (englisch: RF, radio frequency, synthesizer) ausgebildet ist. Der Signalgenerator 140 weist beispielsweise einen Oszillator mit einer Phasenregelschleife (nicht gezeigt) auf und kann in an sich bekannter Weise ein besonders frequenzstabiles Signal (vorliegend beispielsweise im Hochfrequenzbereich zwischen etwa 2400 MHz und etwa 2500 MHz) zum Beispiel für eine Verwendung als Referenzsignal und/oder Anregungssignal für den Oberflächenwellenresonator erzeugen.

Ein von dem Signalgenerator 140 erzeugtes Ausgangssignal kann wie aus Figur 3 ersichtlich über einen ersten Schalter SW1 als Anregungssignal as für einen Oberflächenwellenresonator $SAW_1$ einer Koppeleinrichtung 145 zugeführt werden. Hierzu ist der erste Schalter SW1 in seine in Figur 3 mit der Ziffer "1" bezeichnete erste Schalterstellung zu bringen. An seinem Eingang SW1a erhält der erste Schalter SW1 das Ausgangssignal des Signalgenerators 140, und in Abhängigkeit der Schalterstellung des ersten Schalters SW1 wird das Ausgangssignal des Signalgenerators 140 an dem Ausgang SW1b des ersten Schalters SW1 entweder als Anregungssignal as (Schalterstellung "1") an die Koppeleinrichtung 145 ausgegeben oder als Referenzsignal rs (Schalterstellung "2") an den zweiten Eingangsanschluss E2, wie es weiter unten beschrieben ist.

Die Koppeleinrichtung 145 ist dazu ausgebildet, das Anregungssignal as an wenigstens einen Resonator $SAW_1$, $SAW_N$ auszugeben und ein Ausgangssignal as' des wenigstens einen Resonators $SAW_1$, $SAW_N$ zu empfangen und an wenigstens einen Eingangsanschluss E1 der Sechs-Tor-Schaltung 110 und/oder an einen der Sechs-Tor-Schaltung 110 zugeordneten Leistungsteiler 150 auszugeben. Vorliegend ist zwischen dem ersten Eingangsanschluss E1 der Sechs-Tor-Schaltung 110 und der Koppeleinrichtung 145 ein Leistungsteiler 150 angeordnet, der ein von der Koppeleinrichtung 145 ausgegebenes Signal in an sich bekannter Weise teilt und die hierbei erhaltenen Signalteile wie aus Figur 3 ersichtlich einerseits dem ersten Eingangsanschluss E1 der Sechs-Tor-Schaltung 110 und andererseits einem Eingang 120a der Verzögerungsleitung 120 zuführt.

Auf diese Weise kann der Signalgenerator 140 ein Ausgangssignal bereitstellen, das als Anregungssignal as dem Oberflächenwellenresonator $SAW_1$ zugeleitet wird, und zwar über die Koppeleinrichtung 145, die das Anregungssignal as an einem Eingang entgegennimmt, und die das Anregungssignal as beispielsweise an den ersten Oberflächenwellenresonator $SAW_1$ ausgibt, wodurch der erste Oberflächenwellenresonator $SAW_1$ in an sich bekannter Weise zu Schwingungen, insbesondere Oberflächenwellenschwingungen, angeregt wird und ein Antwortsignal as' abgibt. Die Koppeleinrichtung 145 ist ferner dazu ausgebildet, das Antwortsignal as' des ersten Oberflächenwellenresonators $SAW_1$ zu empfangen und es wie aus Figur 3 ersichtlich an den Leistungsteiler 150 weiterzugeben.

Bei einer Ausführungsform kann die Koppeleinrichtung 145 beispielsweise wenigstens einen Zirkulator und/oder Richtkoppler aufweisen. Alternativ hierzu kann bei einer weiteren Ausführungsform die Koppeleinrichtung 145 wenigstens einen, ggf. auch mehrere, Sende-Empfangsschalter (englisch: RX/TX-switch) umfassen.

Wie vorstehend bereits beschrieben teilt der Leistungsteiler 150 das ihm eingangs zugeführte Antwortsignal as' auf, beispielsweise in zwei Teilsignale derselben Signalleistung, welche vorliegend das elektrische Signal s1 repräsentieren, dessen Frequenz mittels des Messsystems 100a und insbesondere seiner Sechs-Tor-Schaltung 110 ermittelt werden soll, beispielsweise in der vorstehend unter Bezugnahme auf Figur 1 beschriebenen ersten Betriebsart.

Wie vorstehend unter Bezugnahme auf Figur 1 bereits beschrieben, wird dazu das elektrische Signal s1 einerseits direkt dem ersten Eingangsanschluss E1 der Sechs-Tor-Schaltung 110 zugeführt. Andererseits wird das elektrische Signal s1 einem zweiten Eingangsanschluss E2 der Sechs-Tor-Schaltung 110 über die Verzögerungsleitung 120 zugeführt. Hierbei wird am Ausgang 120 bei der Verzögerungsleitung 120 ein verzögertes elektrisches Signal s1' erhalten, das hinsichtlich seiner Frequenz dem elektrischen Signal s1 entspricht, jedoch aufgrund des Durchlaufens der Verzögerungsleitung 120 um eine die Verzögerungsleitung 120 charakterisierende Verzögerungszeit verzögert ist. Mit anderen Worten weist das verzögerte elektrische Signal s1' eine Phasenverschiebung zu dem elektrischen Signal s1 auf, die von den Eigenschaften der Verzögerungsleitung 120 abhängt.

Vorliegend ist zwischen dem Ausgang 120 bei der Verzögerungsleitung 120 und dem zweiten Eingangsanschluss E2 der Sechs-Tor-Schaltung 110 ein zweiter Schalter SW2 angeordnet. Um das verzögerte elektrische Signal s1' von der Verzögerungsleitung 120 zu dem zweiten Eingangsanschluss E2 leiten zu können, ist der zweite Schalter SW2 in seine in Figur 3 mit der Ziffer "1" bezeichnete erste Schalterstellung zu bringen. Dann wird das verzögerte elektrische Signal s1' dem zweiten Eingangsanschluss E2 der Sechs-Tor-Schaltung 110 zugeführt, und es kann eine Messung der Frequenz des elektrischen Signals s1 in der vorstehend bereits mehrfach beschriebenen Weise erfolgen. Beispielsweise kann die Recheneinheit 130 hierzu wiederum ein oder mehrere Ausgangssignale der Sechs-Tor-Schaltung 110 und/oder ein oder mehrere hieraus abgeleitete Signale $B_3$, $B_4$, $B_5$, $B_6$ auswerten.

Bei einer bevorzugten Ausführungsform des Messsystems 100a ist die erste erfindungsgemäße Betriebsart, welche der Frequenzmessung des elektrischen Signals s1 dient, demnach dadurch charakterisiert, dass sowohl der erste Schalter SW1 als auch der zweite Schalter SW2 jeweils ihre erste Schalterstellung (Ziffer "1") annehmen. Diese Betriebsart ist in Figur 3 gezeigt.

Bei einer weiteren vorteilhaften Ausführungsform kann vorgesehen sein, dass mehrere Resonatoren, beispielsweise N viele Resonatoren $SAW_1$, ..., $SAW_N$ vorhanden sind. Diese können beispielsweise in einem Zeitmultiplexbetrieb, also zeitlich nacheinander jeweils mit dem Anregungssignal as beaufschlagt werden, wobei eine entsprechende Frequenzmessung der betreffenden Antwortsignale der mehreren Resonator ebenfalls zeitlich nacheinander erfolgen kann.

Bei einer weiteren Ausführungsform können die mehreren Resonatoren auch unterschiedliche Resonanzfrequenzen aufweisen, und der Signalgenerator 140 kann beispielsweise durch die Recheneinheit 130 vorteilhaft so gesteuert werden, dass er jeweils passende Anregungssignale mit der betreffenden Frequenz für die unterschiedlichen Resonatoren erzeugt.

Besonders vorteilhaft kann auch das in Figur 3 gezeigte Messsystem 100a neben der zur Frequenzmessung des elektrischen Signals s1 verwendbaren ersten Betriebsart die erfindungsgemäße zweite Betriebsart einnehmen, die zur Ermittlung von Störsignalen dienen kann. Hierbei nehmen sowohl der erste Schalter SW1 als auch der zweite Schalter SW2 jeweils ihre zweite Schalterstellung (Ziffer "2") an. Diese Betriebsart ist in Figur 3 nicht abgebildet, wird jedoch nachfolgend erläutert.

Wenn der erste Schalter SW1 seine zweite Schalterstellung einnimmt, wird das von dem Signalgenerator 140 erzeugte Ausgangssignal über den Ausgang SW1b des ersten Schalters SW1 als Referenzsignal rs an den zweiten Schalter SW2 weitergeleitet, der in seiner zweiten Schalterstellung "2" das Referenzsignal rs dem zweiten Eingangsanschluss E2 der Sechs-Tor-Schaltung 110 zuführt. Auf diese Weise wird also direkt das von dem Signalgenerator 140 erzeugte Ausgangssignal als Referenzsignal rs dem zweiten Eingangsanschluss E2 zugeführt.

Da sich der erste Schalter SW1 in der zweiten Betriebsart in seiner zweiten Schalterstellung "2" befindet, wird ferner das Ausgangssignal des Signalgenerators 140 nicht an die Koppeleinrichtung 145 weitergeleitet, sodass dementsprechend auch kein Anregungssignal as von der Koppeleinrichtung 145 an wenigstens einen Resonator $SAW_1$ ausgebbar und ein entsprechendes Antwortsignal as' empfangbar ist.

Vielmehr können in dieser zweiten Betriebsart im Bereich des Messsystems 100a vorhandene Störsignale is' in einen Eingang der Koppeleinrichtung 145 eingekoppelt werden, anstelle eines Antwortsignals as' eines Resonators, sodass die eingekoppelten Störsignale is' dem Leistungsteiler 150 zugeführt und geteilt werden. Daraus ergibt sich am Ausgang des Leistungsteilers 150 ein Störsignal is, das analog zu dem elektrischen Signal s1 in der ersten Betriebsart, direkt dem ersten Eingangsanschluss E1 der Sechs-Tor-Schaltung 110 zugeführt wird. Der andere Teil des Störsignals is wird der Verzögerungsleitung 120 zugeführt, von ihr verzögert, jedoch nicht an den zweiten Eingangsanschluss E2 der Sechs-Tor-Schaltung 110 weitergeleitet, weil der zweite Schalter SW2 in der vorliegend beschriebenen zweiten Betriebsart seine zweite Schalterstellung "2" einnimmt und damit das von dem Signalgenerator 140 bereitgestellte Referenzsignal rs dem zweiten Eingangsanschluss der Sechs-Tor-Schaltung 110 zuleitet.

In der vorliegend beschriebenen zweiten Betriebsart wird dem ersten Eingangsanschluss E1 der Sechs-Tor-Schaltung 110 mithin das gegebenenfalls vorliegende Störsignal is zugeführt, und dem zweiten Eingangsanschluss E2 der Sechs-Tor-Schaltung 110 wird das Referenzsignal rs zugeführt.

Das Messsystem 100 A ist dazu ausgebildet, in dieser zweiten Betriebsart in Abhängigkeit wenigstens eines Ausgangssignals der Sechs-Tor-Schaltung 110 auf das Vorhandensein des Störsignals is, insbesondere im Bereich des ersten Eingangsanschlusses E1, zu schließen. Hierzu kann das Messsystem 100 a bzw. seine Recheneinheit 130 wenigstens ein Ausgangssignal der Sechs-Tor-Schaltung 110 und/oder wenigstens ein hiervon abgeleitetes Signal auswerten.

Besonders bevorzugt ist die Recheneinheit 130 des Messsystems 100a gemäß Figur 3 dazu ausgebildet, in der zweiten Betriebsart vier an unterschiedlichen Ausgangsanschlüssen A1, A2, A3, A4 (Fig. 1) der Sechs-Tor-Schaltung 110 erhaltene Ausgangssignale b3, b4, b5, b6, also alle Ausgangssignale, und/oder hiervon abgeleitete Signale $B_3$, $B_4$, $B_5$, $B_6$ (Fig. 3) auszuwerten und in Abhängigkeit der Auswertung auf ein Störsignal is zu schließen, wodurch sich eine gegenüber der Auswertung von weniger als vier Ausgangssignalen gesteigerte Präzision ergibt.

Bei einer weiteren Ausführungsform kann die Recheneinheit 130 des Messsystems 100a beispielsweise einen Betrag der Ausgangssignale b3, b4, b5, b6, und/oder der hiervon abgeleitete Signale $B_3$, $B_4$, $B_5$, $B_6$ auswerten, um auf das Vorhandensein bzw. eine Leistung des Störsignals is zu schließen bzw. diese zu ermitteln.

Bei einer besonders bevorzugten Ausführungsform kann Recheneinheit 130 eine Amplitude bzw. ein Betrag der abgeleiteten Signale $B_3$, $B_4$, $B_5$, $B_6$ auswerten, um Informationen über ein mögliches Störsignal is zu erlangen. Die Auswertung kann beispielsweise eine Schwellwertdetektion oder dergleichen umfassen. Bei einer weiteren vorteilhaften Ausführungsform kann die Auswertung beispielsweise eine Untersuchung des Betrags der abgeleiteten Signale auf eine zeitliche Änderung hin umfassen.

Bei einer weiteren vorteilhaften Ausführungsform kann zwischen dem Ausgang des Signalgenerators 140 (Fig. 3) und dem Eingang SW1a des ersten Schalters SW1 ein Dämpfungsglied, vorzugsweise ein steuerbares Dämpfungsglied, angeordnet sein, was eine Flexibilität bei dem Betrieb des erfindungsgemäßen Messsystems 100a und die Präzision weiter steigert. Beispielsweise kann das steuerbare Dämpfungsglied durch die Recheneinheit 130 gesteuert werden, um Anregungssignale as unterschiedlicher Amplitude als Ausgangssignal des Signalgenerators 140 auszugeben. Dies kann vorteilhaft für eine Linearisierung des Messsystems 100a verwendet werden und/oder beispielsweise bei Konfigurationen, bei denen mehrere Resonatoren vorhanden und jeweils unterschiedlich weit entfernt von der Koppeleinrichtung 145 angeordnet sind. Hierdurch kann beispielsweise eine entsprechend unterschiedliche Freiraumdämpfung der Anregungssignale as bzw. der entsprechenden Antwortsignale as' der Resonatoren ausgeglichen werden.

Figur 6B zeigt ein vereinfachtes Flussdiagramm einer zweiten Ausführungsform des erfindungsgemäßen Verfahrens, die beispielsweise durch das Messsystem 100a gemäß Figur 3 ausgeführt werden kann.

In einem ersten Schritt 210 werden die beiden Schalter SW1, SW2 jeweils in ihre zweite Schalterstellung "2" versetzt, was beispielsweise unter Steuerung der Recheneinheit 130 erfolgen kann. Dadurch nimmt das Messsystem 100a in Schritt 210 zunächst die zweite Betriebsart an, in der das Vorhandensein von Störsignalen is überprüft wird. Wie vorstehend bereits beschrieben erzeugt der Signalgenerator 140 hierzu ein als Referenzsignal rs verwendbares Ausgangssignal, und dem ersten Eingangsanschluss E1 der Sechs-Tor-Schaltung 110 wird aktiv kein Signal durch das Messsystem 100a bzw. seinen Signalgenerator 140 oder eine sonstige Komponente zugeführt. Die Recheneinheit 130 führt sodann in Schritt 210 eine Auswertung ein oder mehrere Ausgangssignale der Sechs-Tor-Schaltung 110 aus, wie vorstehend bereits beschrieben, wodurch auf das Vorhandensein von Störsignalen is geschlossen werden kann.

Bei einer bevorzugten Ausführungsform ermittelt das Messsystem 100a (Fig. 3), beispielsweise durch die Recheneinheit 130, ein Störsignal charakterisierende Informationen, und sodann wechselt das Messsystem 100a in die erste Betriebsart, vergleiche Schritt 212 von Figur 6B, was bevorzugt in Abhängigkeit der ein Störsignal charakterisierenden Informationen erfolgt. In Schritt 212 kann sodann in der ersten Betriebsart eine Frequenz des elektrischen Signals s1 (Figur 3) ermittelt werden. Hierzu werden wie vorstehend bereits beschrieben die beiden Schalter SW1, SW2 jeweils in ihre erste Schalterstellung "1" versetzt.

Bei einer Ausführungsform ist wenigstens einer der Schalter SW1, SW2 als sog. SPDT-Schalter (Single Pole Double Throw) bzw. Wechselschalter ausgebildet.

Bei einer bevorzugten Ausführungsform ist vorgesehen, dass das Messsystem 100a in Abhängigkeit der ein Störsignal charakterisierenden Informationen eine Wartezeit ermittelt, für die gewartet wird, bevor nach Schritt 210 ein Wechsel von der zweiten Betriebsart in die erste Betriebsart, also zu Schritt 212, erfolgt.

Beispielsweise kann eine vergleichsweise große Wartezeit gewählt werden, sofern die das Störsignal charakterisierenden Informationen angeben, dass ein Störsignal mit einer vergleichsweise großen Signalleistung vorliegt. In diesem Fall ist eine vergleichsweise große Wartezeit vor dem Übergang in die erste Betriebsart, Schritt 212, zweckmäßig, weil beispielsweise davon ausgegangen werden kann, dass das Störsignal bis zu dem Ende der Wartezeit abgeklungen ist bzw. dann eine geringere Signalleistung aufweist.

Beispielsweise kann eine vergleichsweise kleine Wartezeit gewählt werden, sofern die das Störsignal charakterisierenden Informationen angeben, dass ein Störsignal mit einer vergleichsweise kleinen Signalleistung bzw. gar kein Störsignal vorliegt. In diesem Fall kann gegebenenfalls sofort von dem Schritt 210 zu dem Schritt 212 gewechselt werden, also mit der Messung der Frequenz des elektrischen Signals s1 begonnen werden.

Bei einer besonders bevorzugten Ausführungsform kann vorgesehen sein, dass nach der Wartezeit erneut auf Störungen geprüft wird, also der Schritt 210 wiederholt wird, bevor in die erste Betriebsart, also zu Schritt 212, gewechselt wird. Besonders vorteilhaft wird bei dieser Ausführungsform nur dann in die erste Betriebsart, also zu Schritt 212, gewechselt, wenn bei der zweiten Prüfung auf Störungen, welche nach der vorstehend genannten Wartezeit ausgeführt wird, festgestellt worden ist, dass nunmehr keine bzw. keine signifikanten Störsignale vorliegen, sodass eine genaue Messung in dem Schritt 212 möglich ist.

Der Erfindung zufolge wird in der zweiten Betriebsart das Ausgangssignal des Signalgenerators 140, also das Referenzsignal rs, gleichsam als Lokaloszillator-Signal verwendet, um zusammen mit der Sechs-Tor-Schaltung 110 einen Direktmischempfänger (englisch: direct conversion receiver) auszubilden, der ein gegebenenfalls vorhandenes Störsignal is, welches in einem ähnlichen Frequenzbereich liegt, wie das Referenzsignal rs (und welches demnach für eine Messung der Frequenz des elektrischen Signals s1, das bei bevorzugten Ausführungsformen hinsichtlich seiner Frequenz üblicherweise dem Referenzsignal rs entspricht, störend wäre) heruntermischt, also von dem HochfrequenzBereich (englisch: RF) in eine Basisbandlage transformiert. Mit anderen Worten kann das erfindungsgemäße Messsystem 100, 100a neben der Messung der Frequenz eines elektrischen Signals s1 erfindungsgemäß vorteilhaft zur Prüfung auf Störsignale hin genutzt werden, und zwar in der vorstehend beschriebenen zweiten Betriebsart.

Optional können bei manchen Ausführungsformen Tiefpassfilterung ("Basisbandfilter") (nicht gezeigt) vorhanden sein, welche die heruntergemischten Ausgangssignale $B_3$, $B_4$, $B_5$, $B_6$ spektral begrenzen, beispielsweise auf eine Bandbreite, welche auch bei der Messung der Frequenz des elektrischen Signals s1 in der ersten Betriebsart genutzt wird. Dadurch werden für die erfindungsgemäße Betrachtung des Störsignals is in der zweiten Betriebsart vorteilhaft nur diejenigen spektralen Anteile des Störsignals is betrachtet, welche gegebenenfalls auch die Frequenzmessung in der ersten Betriebsart stören könnten. Die Tiefpassfilter können einer Ausführungsform zufolge als diskrete Bauelemente ausgebildet sein. Alternativ kann eine Tiefpassfilterung auch durch die Recheneinheit 130 vorgenommen werden, mittels entsprechender Verfahren zur digitalen Signalverarbeitung.

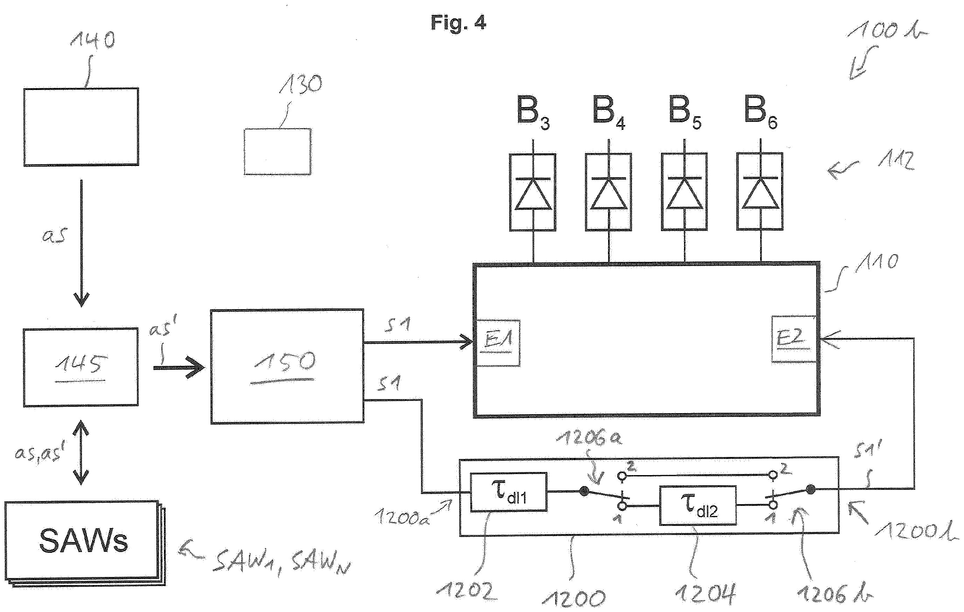

Figur 4 zeigt schematisch ein Blockdiagramm einer dritten Ausführungsform 100b des erfindungsgemäßen Messsystems. Die Komponenten 110, 112, 130, 140, 145, 150 aus Figur 4 entsprechen hinsichtlich ihrer Funktion im Wesentlichen den betreffenden Komponenten der vorstehend unter Bezugnahme auf Figur 3 beschriebenen Ausführungsform 100a, weswegen sie nachfolgend nicht nochmals im Detail beschrieben werden.

Im Unterschied zu der vorstehend unter Bezugnahme auf Figur 3 beschriebenen Ausführungsform 100a des Messsystems weist das Messsystem 100b gemäß Figur 4 eine andersartig ausgebildete Verzögerungsleitung 1200 auf. Die Verzögerungsleitung 1200 weist vorliegend zwei wahlweise einstellbare Verzögerungsleitungslängen auf. Dies wird vorliegend dadurch realisiert, dass eine erste Teil-Verzögerungsleitung 1202 und eine zweite Teil-Verzögerungsleitung 1204 in der Verzögerungsleitung 1200 vorgesehen sind. Durch zwei Schalter 1206a, 1206b, welche beispielsweise durch die Recheneinheit 130 steuerbar sind, kann festgelegt werden, ob ein der Verzögerungsleitung 1200 an ihrem Eingang 1200a zugeführtes elektrisches Signal s1 um eine erste, vergleichsweise kurze, Verzögerungszeit, oder um eine zweite, vergleichsweise lange, Verzögerungszeit, verzögert wird, um an dem Ausgang 1200b das verzögerte Signal s1' zu erhalten.

Sofern beide Schalter 1206a, 1206b der Verzögerungsleitung 1200 jeweils ihren zweiten Schaltzustand, Figur 4 jeweils mit der Ziffer "2" bezeichnet, einnehmen, wird die erste, kürzere Verzögerungszeit durch die Verzögerungsleitung 1200 realisiert. In diesem Fall wirkt also nur die erste Teil-Verzögerungsleitung 1202. Dies charakterisiert eine dritte Betriebsart des Messsystems 100b.

Sofern demgegenüber beide Schalter 1206a, 1206b der Verzögerungsleitung 1200 jeweils ihren ersten Schaltzustand, in Figur 4 jeweils mit der Ziffer "1" bezeichnet, einnehmen, wird die zweite, längere Verzögerungszeit durch die Verzögerungsleitung 1200 realisiert. In diesem Fall wirken also beide nunmehr hintereinander geschalteten Teil-Verzögerungsleitungen 1202, 1204. Dies charakterisiert eine vierte Betriebsart des Messsystems 100b.

Wie vorstehend bereits unter Bezugnahme auf Figur 1 beschrieben kann auch das Messsystem 100b nach Figur 4 eine Frequenz des elektrischen Signals s1 ermitteln. Beispielsweise kann diese Konfiguration dazu verwendet werden, eine (momentane) Resonanzfrequenz wenigstens eines Resonators $SAW_1$, $SAW_N$ zu ermitteln.

Besonders vorteilhaft kann einer Ausführungsform zufolge die vierte Betriebsart für eine Messung der Frequenz des elektrischen Signals s1 gewählt werden, also ein Betrieb der Verzögerungsleitung 1200 mit großer Verzögerungszeit, wodurch sich vorteilhaft eine besonders hohe Messgenauigkeit ergibt.

Besonders vorteilhaft kann einer weiteren Ausführungsform zufolge die dritte Betriebsart für eine Messung der Frequenz des elektrischen Signals s1 gewählt werden, also ein Betrieb der Verzögerungsleitung mit vergleichsweise kleiner Verzögerungszeit, wodurch sich vorteilhaft ein großer Eindeutigkeitsbereich für die Ermittlung der Frequenz des elektrischen Signals s1 ergibt. Bei manchen Ausführungsformen kann der Eindeutigkeitsbereich vorteilhaft das komplette ISM-Frequenzband im Bereich von etwa 2400 MHz bis etwa 2500 MHz umfassen.

Bei weiteren Ausführungsformen ist es auch denkbar, zur Ermittlung der Frequenz des elektrischen Signals s1 Messungen sowohl in der vierten Betriebsart als auch in der dritten Betriebsart vorzunehmen.

Figur 6C zeigt ein vereinfachtes Flussdiagramm einer dritten Ausführungsform des erfindungsgemäßen Verfahrens, die beispielsweise durch das Messsystem 100b gemäß Figur 4 ausgeführt werden kann. In einem ersten Schritt 220 wird das Messsystem 100 B gemäß Figur 4 in der dritten Betriebsart betrieben, also mit vergleichsweise kurzer Verzögerungszeit der Verzögerungsleitung 1200. Dadurch ergibt sich wie erwähnt ein großer Eindeutigkeitsbereich für die Frequenzmessung. Insbesondere kann hierbei auch festgestellt werden, ob ein Störsignal vorliegt. Vorteilhaft kann hierzu der Signalgenerator 140 dazu ausgebildet sein, während der dritten Betriebsart ein Ausgangssignal als Anregungssignal as für einen Resonator auszugeben. In diesem Fall kann demnach ein gegebenenfalls im Bereich des Messsystems 100b, insbesondere seines ersten Eingangsanschlusses E1, vorhandenes Störsignal (nicht gezeigt) detektiert werden.

Sodann wird gemäß Figur 6C zu dem Schritt 222 gewechselt, in dem das Messsystem 100b die vierte Betriebsart annimmt, also mit vergleichsweise großer Verzögerungszeit der Verzögerungsleitung 1200, was eine besonders große Messgenauigkeit bei der Messung der Frequenz des elektrischen Signals s1 ergibt. In diesem Fall kann der Signalgenerator 140 ein oder mehrere Anregungssignale as zur Anregung des Resonators ausgeben, und ein Antwortsignal as' des Resonators wird nach Teilen durch den Leistungsteiler 150 der Sechs-Tor-Schaltung 110 der vorstehend bereits mehrfach beschriebenen Frequenzmessung zugeführt.

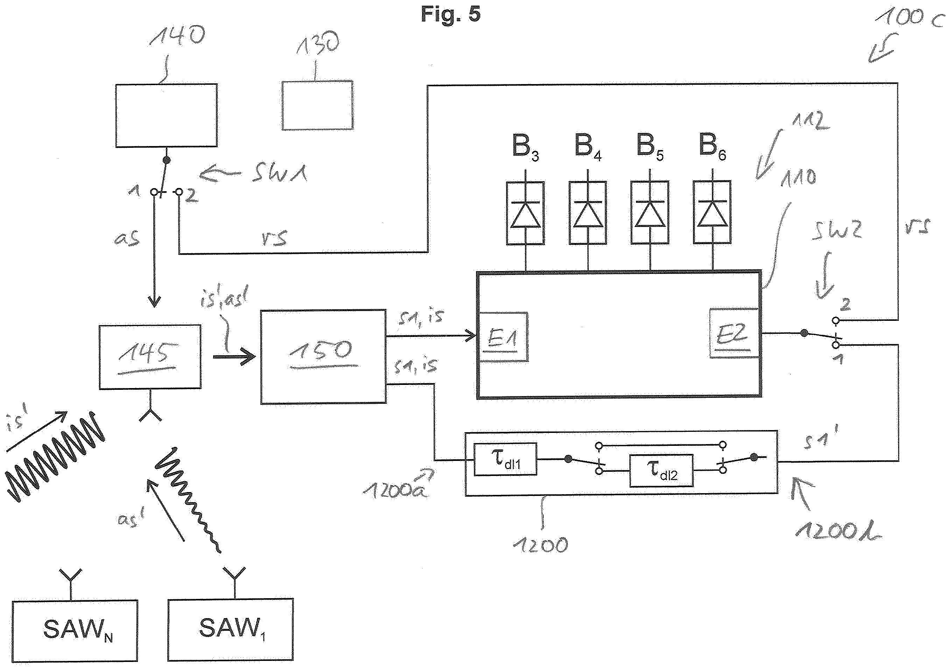

Figur 5 zeigt schematisch ein Blockdiagramm einer vierten Ausführungsform 100c des erfindungsgemäßen Messsystems, welches im Wesentlichen einer Kombination der vorstehend unter Bezugnahme auf die Figuren 3, 4 beschriebenen Erfindungsvarianten entspricht.

Das Messsystem 100c kann über den ersten Schalter SW1 wahlweise der Koppeleinrichtung 145 ein Anregungssignal as zur Beaufschlagung wenigstens eines Resonators SAW$_1$ oder dem zweiten Schalter SW2 bzw. dem in Schalterstellung "2" damit verbundenen zweiten Eingangsanschluss E2 der Sechs-Tor-Schaltung 110 ein Referenzsignal rs zuführen.

Ferner kann das Messsystem 100c durch den zweiten Schalter SW2 zwischen dem Referenzsignal und einem verzögerten elektrischen Signal s1' umschalten.

Auf diese Weise kann auch das Messsystem 100c gemäß Figur 5 in der erfindungsgemäßen ersten Betriebsart betrieben werden, bei dem die Frequenz des elektrischen Signals s1 gemessen wird. Hierbei sind die beiden Schalter SW1, SW2 jeweils in ihrer ersten Schalterstellung "1".

Aufgrund der hinsichtlich ihrer Verzögerungszeit steuerbaren Verzögerungsleitung 1200 kann das Messsystem 100c in der ersten Betriebsart vorteilhaft noch zwischen einer Messung mit vergleichsweise langer Verzögerungszeit und vergleichsweise kurzer Verzögerungszeit umschalten, vergleiche die in Figur 5 nicht näher bezeichneten Schalter der Verzögerungsleitung 1200, welche vorstehend unter Bezugnahme auf Figur 4 bereits im Detail beschrieben worden sind.

Sofern die beiden Schalter SW1, SW2 des Messsystems 100c jeweils in ihrer zweiten Schalterstellung "2" sind, ist die Messung eines Störsignals is wie vorstehend bereits unter Bezugnahme auf Figur 2 beschrieben ermöglicht.

Bei einer weiteren vorteilhaften Ausführungsform ist vorgesehen, dass das elektrische Signal s1 bzw. das Anregungssignal as und/oder das Referenzsignal rs in wenigstens einem ISM (industrial, scientific, medical) - Frequenzband liegt, besondere in einem Frequenzbereich zwischen etwa 2400 MHz und etwa 2500 MHz.

Bei einer weiteren vorteilhaften Ausführungsform ist vorgesehen, dass das Messsystem 100, 100a, 100b, 100c zumindest zeitweise wenigstens einen Datenrahmen, insbesondere einen beacon-Datenrahmen gemäß der IEEE 802.11 Protokollfamilie, aussendet (Datenrahmen anderer Protokolle sind ebenfalls denkbar), insbesondere um anderen gegebenenfalls in Funkreichweite befindlichen Systemen das Vorhandensein eines Senders zu suggerieren, der z.B. gemäß der IEEE 802.11 Protokollfamilie arbeitet. Dadurch kann vorteilhaft erreicht werden, dass andere Systeme (z.B. WLAN, wireless local area network, router), welche den beacon-Datenrahmen des erfindungsgemäßen Messsystems 100, 100a, 100b, 100c auswerten, darauf schließen, dass der von dem Messsystem 100, 100a, 100b, 100c für die Aussendung des beacon-Datenrahmens verwendete Kommunikations- bzw. Funkkanal besetzt ist, was diese anderen Systeme gegebenenfalls dazu veranlassen kann, fortan den betreffenden Funkkanal nicht mehr zu benutzen, wodurch sich eine geringere Beaufschlagung des von dem erfindungsgemäßen Messsystem 100, 100a, 100b, 100c verwendeten Frequenzbereichs durch Störsignale is ergibt.

Bei einer Ausführungsform kann ein derartiges "WLAN-Signal" bzw. ein beacon-Datenrahmen gemäß der IEEE 802.11 Protokollfamilie beispielsweise unter Verwendung des Signalgenerators 140 erzeugt werden, der hierzu entsprechend von der Recheneinheit 130 angesteuert wird.

Eine Abstrahlung des erzeugten "WLAN-Signal" kann beispielsweise unter Verwendung der Koppeleinrichtung 145 erfolgen, analog zu der Beaufschlagung wenigstens eines Resonators mit einem Anregungssignal.

Bei einer weiteren vorteilhaften Ausführungsform ist vorgesehen, dass das Messsystem 100, 100a, 100b, 100c dann wenigstens einen Datenrahmen, insbesondere beacon-Datenrahmen gemäß der IEEE 802.11 Protokollfamilie, aussendet, wenn zuvor in der zweiten Betriebsart festgestellt worden ist, dass ein Störsignal is mit einer einen Schwellwert überschreitenden Signalleistung vorliegt.

Bei einer weiteren vorteilhaften Ausführungsform kann alternativ oder ergänzend zu der Sechs-Tor-Schaltung 110 auch eine Schaltung zum Messen von Phasendifferenzen verwendet werden, um die frequenzabhängige Phasendifferenz ($d\_phi = 2 * Pi * f * t\_dl$) zwischen dem elektrischen Signal s1 und dem verzögerten elektrischen Signal s1' für eine nachfolgende Berechnung seiner Frequenz f zu ermitteln. Beispielsweise ist es denkbar, einen oder mehrere I/Q-Mischer zu verwenden.

Bei einer weiteren vorteilhaften Ausführungsform ist vorgesehen, dass das Messsystem 100, 100a, 100b, 100c dazu ausgebildet ist, zumindest zeitweise ein Linearisierungssignal einerseits direkt dem ersten Eingangsanschluss E1 (Fig. 1) der Sechs-Tor-Schaltung 110 und andererseits über die Verzögerungsleitung 120 dem zweiten Eingangsanschluss E2 der Sechs-Tor-Schaltung 110 zuzuführen. Damit ist vorteilhaft die Möglichkeit der Linearisierung des Messsystems, insbesondere der Kalibrierung der Verzögerungsleitung 120 gegeben. Dies charakterisiert eine fünfte Betriebsart des erfindungsgemäßen Messsystems, die vorzugsweise beispielsweise alternierend zu wenigstens einer anderen der vorstehend bereits beschriebenen Betriebsarten ausführbar ist. Besonders bevorzugt kann die der Kalibrierung dienende fünfte Betriebsart periodisch ausgeführt werden.

Das Linearisierungssignal kann ähnlich wie das elektrische Signal s1 bzw. das Anregungssignal as bzw. das Referenzsignal rs beispielsweise ein Sinus-förmiges Signal sein, wobei das Linearisierungssignal vorteilhaft eine bekannte Frequenz und Amplitude aufweist. Damit ist die Möglichkeit der Linearisierung des Messsystems, insbesondere der Kalibrierung der Verzögerungsleitung 120, 1200 gegeben, beispielsweise unter Verwendung der folgenden, vorstehend bereits beschriebenen, Gleichung: d_phi = 2 * Pi * f * t_dl, die umgeformt werden kann zu: t_dl = d_phi / (2 * Pi * f). Mit anderen Worten kann bei bekannter Phasenverschiebung d_phi (ermittelbar durch die Auswertung des Linearisierungssignals durch die Sechs-Tor-Schaltung 110) und bekannter Frequenz f des Linearisierungssignals die aktuelle Verzögerungszeit t_dl der Verzögerungsleitung 120, 1200 ermittelt werden. Mit dem so gewonnenen aktuellen Wert für die Verzögerungszeit kann sodann eine Frequenzmessung beispielsweise mittels der vorstehend beschriebenen ersten Betriebsart ausgeführt werden, welche aufgrund der vorangehenden Kalibrierung der Verzögerungszeit besonders genau ist.

Bei weiteren vorteilhaften Ausführungsformen kann die vorstehend beschriebene Kalibrierung der Verzögerungszeit bzw. Linearisierung jeweils vor wenigstens einem der Schritte 200, 202, 210, 212, 220, 222 der unter Bezugnahme auf Figur 6A bis Figur 6C beschriebenen Ausführungsformen des erfindungsgemäßen Verfahrens ausgeführt werden.

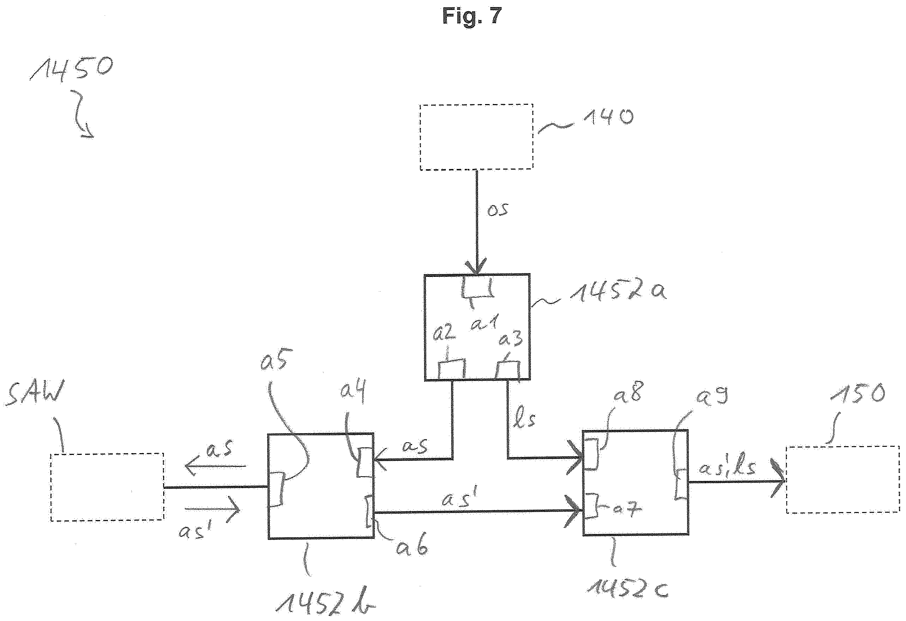

Figur 7 zeigt ein vereinfachtes Blockdiagramm einer Ausführungsform einer erfindungsgemäßen Koppeleinrichtung 1450. Beispielsweise kann die vorstehend beschriebene Koppeleinrichtung 145 (Fig. 3, 4, 5) zumindest teilweise oder vollständig die nachstehend unter Bezugnahme auf Figur 7 beschriebene Konfiguration 1450 aufweisen.

Die Koppeleinrichtung 1450 weist vorliegend drei SPDT-Schalter ("Single Pole Double Throw", Wechselschalter) 1452a, 1452b, 1452c auf. Zusätzlich zu den drei Wechselschaltern 1452a, 1452b, 1452c sind in Figur 7 jeweils als gestricheltes Rechteck noch der Signalgenerator 140, ein Resonator SAW und der Leistungsteiler 150 angedeutet, um den Signalfluss in der Koppeleinrichtung 1450 auch in Bezug auf die mit ihr verbundenen Komponenten 140, SAW, 150 zu beschreiben.

Wie aus Figur 7 ersichtlich ist, ist dem ersten Wechselschalter 1452a an dessen ersten Anschluss a1 ein Ausgangssignal os des Signalgenerators 140 zuführbar. Bei dem Ausgangssignal os handelt es sich beispielsweise um das vorstehend beschriebene Anregungssignal as und/oder das vorstehend beschriebenen Referenzsignal rs und/oder um das vorstehend beschriebene Linearisierungssignal ls.

Der erste Wechselschalter 1452a kann seinen ersten Anschluss a1 wahlweise mit seinem zweiten Anschluss a2 oder seinem dritten Anschluss a3 verbinden. Vergleichbares gilt für den ersten Anschluss a5 des zweiten Wechselschalters 1452b und dessen zweiten bzw. dritten Anschluss a4, a6, sowie für den ersten Anschluss a9 des dritten Wechselschalters 1352c und dessen zweiten bzw. dritten Anschluss a7, a8. Die vorstehend genannten Verbindungsmöglichkeiten können beispielsweise unter Steuerung der Recheneinheit 130 (Figur 1) eingestellt werden. Insoweit entsprechen die Wechselschalter 1452a, 1452b, 1452c in ihrer Funktion i.w. dem vorstehend beschriebenen ersten bzw. zweiten Schalter SW1, SW2 (Fig. 3).

Sofern beispielsweise ein von dem Signalgenerator 140 erzeugtes Ausgangssignal os als Anregungssignal as dem Resonator SAW zugeführt werden soll, verbindet der erste Wechselschalter 1452a seinen ersten Anschluss a1 mit seinem zweiten Anschluss a2, sodass das Ausgangssignal os als Anregungssignal as an den zweiten Wechselschalter 1452b, nämlich dessen zweiten Anschluss a4, ausgegeben wird. Der zweite Wechselschalter 1452b verbindet dementsprechend seinen ersten Anschluss a5 mit dem zweiten Anschluss a4, um das Anregungssignal as an den Resonator SAW auszugeben.

Obwohl vorliegend in Figur 7 eine direkte Verbindung (Verbindungslinie) zwischen dem zweiten Wechselschalter 1452b und dem Resonator SAW angedeutet ist, kann bei manchen Ausführungsformen das Anregungssignal as von dem ersten Anschluss a5 des zweiten Wechselschalters 1452b über einen Koppler oder eine Antenne oder ein Kabel an den Resonator SAW übertragen werden.

Zum Empfang des Antwortsignals as' des Resonators SAW kann der zweite Wechselschalter 1452b seinen ersten Anschluss a5 sodann mit seinem dritten Anschluss a6 verbinden, um das Antwortsignal as' über den dritten Anschluss a6 an den dritten Wechselschalter 1452c, nämlich dessen zweiten Anschluss a7, auszugeben. Der dritte Wechselschalter 1452c kann schließlich seinen zweiten Anschluss a7 mit seinem ersten Anschluss a9 verbinden, um das Antwortsignal as' beispielsweise an den Leistungsteiler 150 auszugeben, sodass das Antwortsignal as' am Ausgang des Leistungsteilers 150 in Form des elektrischen Signals s1 gemäß der vorstehend unter Bezugnahme auf Figur 1 beschriebenen Ausführungsform vorliegt und hinsichtlich seiner Frequenz auswertbar ist.

Bei einer bevorzugten Ausführungsform kann das Anregungssignal as einen Puls mit einer Pulsdauer von beispielsweise wenigen Mikrosekunden aufweisen. Sobald der betreffende Puls an den Resonator SAW ausgegeben worden ist, kann der zweite Wechselschalter 1452b seinen Schaltzustand von der Verbindung der Anschlüsse a4, a5 zu der Verbindung der Anschlüsse a5, a6 ändern, um die Weiterleitung des Antwortsignals as' wie vorstehend beschrieben zu ermöglichen. Wiederum kann eine entsprechend Steuerung der Schaltzustände des zweiten Wechselschalters 1452b beispielsweise durch die Recheneinheit 130 bzw. eine sonstige Komponente (z.B. diskrete Logik, nicht gezeigt) des erfindungsgemäßen Messsystems erfolgen.

Bei einer weiteren vorteilhaften Ausführungsform ist vorgesehen, dass das von dem Signalgenerator 140 erzeugte Ausgangssignal os als Linearisierungssignal ls direkt dem Leistungsteiler 150 zugeführt wird. Dies kann vorteilhaft ebenfalls durch die in Figur 7 abgebildete Konfiguration der Koppeleinrichtung 1450 erfolgen. Hierzu wird der erste Wechselschalter 1452a so gesteuert, dass er seine Anschlüsse a1, a3 miteinander verbindet, um das Linearisierungssignal ls an den dritten Wechselschalter 1452c, nämlich dessen dritten Anschluss a8, auszugeben. Ferner wird der dritte Wechselschalter 1452c so gesteuert, dass er seine Anschlüsse a8, a9 miteinander verbindet, so dass das Linearisierungssignal ls über seinen Anschluss a9 an den Leistungsteiler 150 ausgegeben wird. In diesem Fall wird also kein Signal an den Resonator SAW ausgegeben, sondern das Linearisierungssignal ls mit bekannter Frequenz und Amplitude wird über die Koppeleinrichtung 1450 direkt von dem Signalgenerator 140 an den Leistungsteiler 150 zur Auswertung durch die Sechs-Tor-Schaltung 110 (Fig. 1) ausgegeben. Sodann kann die vorstehend bereits beschriebene Ermittlung der Verzögerungszeit der Verzögerungsleitung 120, 1200 erfolgen.

Bei den bereits vorstehend unter Bezugnahme auf die Figuren 3, 5 beschriebenen Ausführungsformen des erfindungsgemäßen Messsystems ist einem dem Resonator SAW1 zugeordneten Anschluss der Koppeleinrichtung 145 beispielhaft ein Antennensymbol 146 zugeordnet, welches eine drahtlose Übermittlung des Anregungssignals as an den jeweiligen Resonator $SAW_1$, ..., $SAW_N$ bzw. eine drahtlose Übermittlung des Antwortsignals as' von dem betreffenden Resonator an den Anschluss der Koppeleinrichtung 145 veranschaulicht.

Die drahtlose Übermittlung der Signale as, as' kann bei manchen Ausführungsformen besonders vorteilhaft eingesetzt werden, da keinerlei Verbindungsleitungen zwischen einem beispielsweise zur Längenmessung bzw. zur Messung von Spannungen bzw. Dehnungen verwendeten Resonator $SAW_1$ und den restlichen Komponenten des Messsystems erforderlich sind.

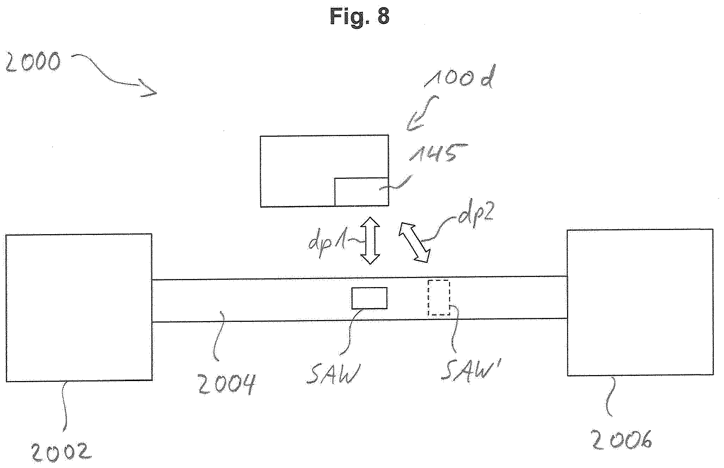

Besonders vorteilhaft kann das erfindungsgemäße Messsystem daher beispielsweise auch zur berührungslosen Messung von physikalischen Größen bewegter Systeme verwendet werden, welche einen Einfluss auf die Resonanzfrequenz des Resonators SAW haben. Beispielsweise kann das erfindungsgemäße Messsystem ganz besonders vorteilhaft zur Messung einer Torsion einer mechanischen Welle verwendet werden. Figur 8 zeigt ein Blockdiagramm einer entsprechenden Ausführungsform 100d. Ebenfalls in Figur 8 abgebildet ist ein mechanisches System 2000, bei dem ein Drehantrieb 2002 wie beispielsweise ein elektrischer Motor über eine Welle 2004 ein Aggregat 2006 wie beispielsweise ein Getriebe, antreibt. Dem mechanischen System 2000 ist ein erfindungsgemäßes Messsystem 100d zugeordnet, welches eine berührungslose Abfrage von wenigstens einem auf der Welle 2004 angeordneten Resonator SAW ermöglicht, vergleiche den Doppelpfeil dp1. Der Resonator SAW ist bevorzugt so mit der Oberfläche der Welle 2004 verbunden, dass mechanische Spannungs- bzw. Dehnungszustände sich wenigstens teilweise auch auf den Resonator SAW übertragen, wodurch sich dessen Resonanzfrequenz ändert.

Die momentane Resonanzfrequenz des Resonators SAW kann unter Verwendung des erfindungsgemäßen Messsystems 100d wie folgt ermittelt werden. Das Messsystem 100d beaufschlagt den Resonator SAW mit einem Anregungssignal as und empfängt ein in Reaktion hierauf von dem Resonator SAW abgestrahltes Antwortsignal as', welches durch die Sechs-Tor-Schaltung 110 des Messsystems 100d hinsichtlich seiner Frequenz ausgewertet wird. Aus der Frequenz kann beispielsweise auf eine Dehnungsbeanspruchung des Resonators SAW und damit auch der Welle 2004 geschlossen werden.

Eine berührungslose Abfrage dp1 des Resonators SAW ist vorteilhaft dadurch ermöglicht, dass das Messsystem 100d, vergleichbar zu der in Figur drei abgebildeten Konfiguration 100a, eine Koppeleinrichtung 145 aufweist, deren dem Resonator SAW zugeordneter Anschluss über eine Antenne 146 zur drahtlosen Übertragung des Anregungssignals as von der Koppeleinrichtung 145 zu dem Resonator SAW und zum Empfang des Antwortsignals as' von dem Resonator SAW verfügt. Damit kann unabhängig von einer momentanen Winkelposition der Welle 2004 der Resonator SAW abgefragt und seine momentane Resonanzfrequenz im Sinne der ersten erfindungsgemäßen Betriebsart ermittelt werden.

Optional kann das Messsystem 100d auch zur Abfrage weiterer Resonatoren SAW' ausgebildet sein, die beispielsweise ebenfalls auf der Welle 2004 angeordnet sein können, vergleiche den weiteren Doppelpfeil dp2 der Figur 8.

Bei weiteren Ausführungsformen kann das Messsystem 100d gemäß Figur 8, insbesondere hinsichtlich seiner Komponenten 110, 120, 1200, 130, 140, 145, 150, wenigstens teilweise so ausgebildet sein wie eine oder mehrere der unter Bezugnahme auf die Figuren 1 bis 5 beschriebenen Varianten.

**Patentansprüche**

1. Elektrisches Messsystem (100; 100a; 100b; 100c; 100d) mit einer Sechs-Tor-Schaltung (110), einer Verzögerungsleitung (120), und einer Recheneinheit (130), wobei in einer ersten Betriebsart ein elektrisches Signal (s1) einerseits direkt an einen ersten Eingangsanschluss (E1) und andererseits über die Verzögerungsleitung (120) an einen zweiten Eingangsanschluss (E2) der Sechs-Tor-Schaltung (110) zuführbar ist, und wobei die Recheneinheit (130) dazu ausgebildet ist, eine Frequenz des Signals (s1) in Abhängigkeit wenigstens eines Ausgangssignals (b3, b4, b5, b6) der Sechs-Tor-Schaltung (110) zu ermitteln, **dadurch gekennzeichnet, dass**

das Messsystem (100; 100a; 100b; 100c; 100d) dazu ausgebildet ist, in einer zweiten Betriebsart dem ersten Eingangsanschluss (E1) der Sechs-Tor-Schaltung (110) kein Signal zuzuführen und dem zweiten Eingangsanschluss (E2) der Sechs-Tor-Schaltung (110) ein vorgebbares Referenzsignal (rs) zuzuführen, wobei das Messsystem (100; 100a; 100b; 100c; 100d) ferner dazu ausgebildet ist, in der zweiten Betriebsart in Abhängigkeit wenigstens eines Ausgangssignals (b3, b4, b5, b6) der Sechs-Tor-Schaltung (110) auf das Vorhandensein eines Störsignals (is), insbesondere im Bereich des ersten Eingangsanschlusses (E1), zu schließen.

2. Messsystem (100; 100a; 100b; 100c; 100d) nach Anspruch 1, wobei die Recheneinheit (130) dazu ausgebildet ist, in der zweiten Betriebsart wenigstens zwei an unterschiedlichen Ausgangsanschlüssen (A1, A2) der Sechs-Tor-Schaltung (110) erhaltene Ausgangssignale (b3, b4) und/oder hiervon abgeleitete Signale ($B_3$, $B_4$) auszuwerten und in Abhängigkeit der Auswertung auf ein Störsignal (is) zu schließen, wobei die Recheneinheit (130) insbesondere dazu ausgebildet ist, in der zweiten Betriebsart vier an unterschiedlichen Ausgangsanschlüssen (A1, A2, A3, A4) der Sechs-Tor-Schaltung (110) erhaltene Ausgangssignale (b3, b4, b5, b6) und/oder hiervon abgeleitete Signale ($B_3$, $B_4$, $B_5$, $B_6$) auszuwerten und in Abhängigkeit der Auswertung auf ein Störsignal (is) zu schließen.

3. Messsystem (100; 100a; 100b; 100c; 100d) nach einem der vorstehenden Ansprüche, wobei die Recheneinheit (130) dazu ausgebildet ist, wenigstens zwei Ausgangssignale (b3, b4) und/oder hiervon abgeleitete Signale ($B_3$, $B_4$) im Wesentlichen gleichzeitig zu erfassen.

4. Messsystem (100; 100a; 100b; 100c; 100d) nach einem der vorstehenden Ansprüche, wobei das Messsystem (100; 100a; 100b; 100c; 100d) dazu ausgebildet ist, die zweite Betriebsart anzunehmen, um das Vorhandensein von möglichen Störsignalen zu untersuchen, wodurch ein Störsignal charakterisierende Informationen erhalten werden, und wobei das Messsystem (100; 100a; 100b; 100c; 100d) dazu ausgebildet ist, nach der zweiten Betriebsart in Abhängigkeit der ein Störsignal charakterisierenden Informationen in die erste Betriebsart zu wechseln, um eine Frequenz des elektrischen Signals (s1) zu ermitteln.

5. Messsystem (100; 100a; 100b; 100c; 100d) nach einem der vorstehenden Ansprüche, wobei das Messsystem (100; 100a; 100b; 100c; 100d) wenigstens einen Resonator ($SAW_1$, $SAW_N$) aufweist, der dazu ausgebildet ist, das elektrische Signal (s1) bereitzustellen, wobei insbesondere der wenigstens eine Resonator ($SAW_1$, $SAW_N$) als akustischer Oberflächenwellenresonator ausgebildet ist.

6. Messsystem (100; 100a; 100b; 100c; 100d) nach einem der vorstehenden Ansprüche, wobei das Messsystem (100; 100a; 100b; 100c; 100d) wenigstens einen Signalgenerator (140) aufweist, der dazu ausgebildet ist, das Referenzsignal (rs) und/oder ein Anregungssignal (as) für einen bzw. den Resonator ($SAW_1$, $SAW_N$) bereitzustellen.

7. Messsystem (100; 100a; 100b; 100c; 100d) nach einem der vorstehenden Ansprüche, wobei das Messsystem (100; 100a; 100b; 100c; 100d) eine Koppeleinrichtung (145; 1450) aufweist, die dazu ausgebildet ist, ein Anregungssignal (as) an wenigstens einen Resonator ($SAW_1$, $SAW_N$) auszugeben und ein Ausgangssignal (as') des wenigstens einen Resonators ($SAW_1$, $SAW_N$) zu empfangen und an wenigstens einen Eingang (E1, E2) der Sechs-Tor-Schaltung (110) und/oder an einen der Sechs-Tor-Schaltung (110) zugeordneten Leistungsteiler (150) auszugeben.

8. Messsystem (100; 100a; 100b; 100c; 100d) nach einem der vorstehenden Ansprüche, wobei das Messsystem (100; 100a; 100b; 100c; 100d) einen ersten Schalter (SW1) aufweist, der dazu ausgebildet ist, ein an seinem Eingang (SW1a) zugeführtes Eingangssignal wahlweise an einem ersten Ausgangsanschluss seines Ausgangs (SW1b) oder an einem zweiten Ausgangsanschluss seines Ausgangs (SW1b) auszugeben, wobei insbesondere der Eingang des ersten Schalters (SW1) mit einem bzw. dem Signalgenerator (140) verbindbar ist, wobei der erste Ausgangsanschluss des ersten Schalters (SW1) mit einer bzw. der Koppeleinrichtung (145; 1450) verbindbar ist, wobei der zweite Ausgangsanschluss des ersten Schalters (SW1) mit wenigstens einem Eingang (E1, E2) der Sechs-Tor-Schaltung (110) und/oder einem Eingang eines der Sechs-Tor-Schaltung (110) zugeordneten Leistungsteilers (150) verbindbar ist.

9. Messsystem (100; 100a; 100b; 100c; 100d) nach einem der vorstehenden Ansprüche, wobei das Messsystem (100; 100a; 100b; 100c; 100d) einen zweiten Schalter (SW2) aufweist, der dazu ausgebildet ist, den zweiten Eingang (E2) der Sechs-Tor-Schaltung (110) wahlweise mit einer ein bzw. das Referenzsignal (rs) bereitstellenden Quelle (140) oder einem Ausgang (120b; 1200b) der Verzögerungsleitung (120; 1200) zu verbinden.

10. Messsystem (100; 100a; 100b; 100c; 100d) nach einem der vorstehenden Ansprüche, wobei die Verzögerungsleitung (1200) wenigstens zwei wahlweise einstellbare Verzögerungsleitungslängen aufweist.

**11.** Messsystem (100; 100a; 100b; 100c; 100d) nach Anspruch 10, wobei das Messsystem (100; 100a; 100b; 100c; 100d) dazu ausgebildet ist, in einer dritten Betriebsart eine erste Verzögerungsleitungslänge der Verzögerungsleitung (1200) einzustellen, und in einer vierten Betriebsart eine zweite Verzögerungsleitungslänge der Verzögerungsleitung (1200) einzustellen, wobei die zweite Verzögerungsleitungslänge verschieden ist von der ersten Verzögerungsleitungslänge, wobei insbesondere die zweite Verzögerungsleitungslänge größer ist als die erste Verzögerungsleitungslänge.

**12.** Messsystem (100; 100a; 100b; 100c; 100d) nach einem der vorstehenden Ansprüche, wobei das Messsystem (100; 100a; 100b; 100c; 100d) dazu ausgebildet ist, zumindest zeitweise ein Linearisierungssignal (ls) einerseits direkt dem ersten Eingangsanschluss (E1) der Sechs-Tor-Schaltung (110) und andererseits über die Verzögerungsleitung (120) dem zweiten Eingangsanschluss (E2) der Sechs-Tor-Schaltung (110) zuzuführen.

**13.** Verfahren zum Betreiben eines elektrischen Messsystems (100; 100a; 100b; 100c; 100d) mit einer Sechs-Tor-Schaltung (110), einer Verzögerungsleitung (120), und einer Recheneinheit (130), wobei in einer ersten Betriebsart ein elektrisches Signal (s1) einerseits direkt an einen ersten Eingangsanschluss (E1) und andererseits über die Verzögerungsleitung (120) an einen zweiten Eingangsanschluss (E2) der Sechs-Tor-Schaltung (110) zugeführt wird, und wobei die Recheneinheit (130) eine Frequenz des Signals (s1) in Abhängigkeit wenigstens eines Ausgangssignals (b3, b4, b5, b6) der Sechs-Tor-Schaltung (110) ermittelt, **dadurch gekennzeichnet, dass**

das Messsystem (100) in einer zweiten Betriebsart dem ersten Eingangsanschluss (E1) der Sechs-Tor-Schaltung (110) kein Signal zuführt und dem zweiten Eingangsanschluss (E2) der Sechs-Tor-Schaltung (110) ein vorgebbares Referenzsignal (rs) zuführt, wobei das Messsystem (100) ferner in der zweiten Betriebsart in Abhängigkeit wenigstens eines Ausgangssignals (b3, b4, b5, b6) der Sechs-Tor-Schaltung (110) auf das Vorhandensein eines Störsignals (is), insbesondere im Bereich des ersten Eingangsanschlusses (E1), schließt.

**14.** Verfahren nach Anspruch 13, wobei die Recheneinheit (130) in der zweiten Betriebsart wenigstens zwei an unterschiedlichen Ausgangsanschlüssen (A1, A2) der Sechs-Tor-Schaltung (110) erhaltene Ausgangssignale (b3, b4) und/oder hiervon abgeleitete Signale ($B_3$, $B_4$) auswertet und in Abhängigkeit der Auswertung auf ein Störsignal (is) schließt, wobei die Recheneinheit (130) insbesondere in der zweiten Betriebsart vier an unterschiedlichen Ausgangsanschlüssen (A1, A2, A3, A4) der Sechs-Tor-Schaltung (110) erhaltene Ausgangssignale (b3, b4, b5, b6) und/oder hiervon abgeleitete Signale ($B_3$, $B_4$, $B_5$, $B_6$) auswertet und in Abhängigkeit der Auswertung auf ein Störsignal (is) schließt.

**15.** Verfahren nach einem der Ansprüche 13 bis 14, wobei die Recheneinheit (130) wenigstens zwei Ausgangssignale (b3, b4) und/oder hiervon abgeleitete Signale ($B_3$, $B_4$) im Wesentlichen gleichzeitig erfasst.

**16.** Verfahren nach einem der Ansprüche 13 bis 15, wobei das Messsystem (100; 100a; 100b; 100c; 100d) die zweite Betriebsart annimmt, um das Vorhandensein von möglichen Störsignalen zu untersuchen, wodurch ein Störsignal charakterisierende Informationen erhalten werden, und wobei das Messsystem (100; 100a; 100b; 100c; 100d) nach der zweiten Betriebsart in Abhängigkeit der ein Störsignal charakterisierenden Informationen in die erste Betriebsart wechselt, um eine Frequenz des elektrischen Signals (s1) zu ermitteln.

**17.** Verfahren nach Anspruch 16, wobei das Messsystem (100; 100a; 100b; 100c; 100d) in Abhängigkeit der ein Störsignal charakterisierenden Informationen eine Wartezeit ermittelt, für die gewartet wird, bevor ein Wechsel von der zweiten Betriebsart in die erste Betriebsart erfolgt.

**18.** Verfahren nach einem der Ansprüche 13 bis 17, wobei das das Messsystem (100; 100a; 100b; 100c; 100d) wenigstens einen Signalgenerator (140) aufweist, und mittels des Signalgenerators (140) ein bzw. das Referenzsignal (rs) und/oder ein Anregungssignal (as) für einen Resonator ($SAW_1$, $SAW_N$) bereitstellt.

**19.** Verfahren nach einem der Ansprüche 13 bis 18, wobei das Messsystem (100; 100a; 100b; 100c; 100d) eine Koppeleinrichtung (145; 1450) aufweist, wobei das Messsystem (100; 100a; 100b; 100c; 100d) ein Anregungssignal (as) mittels der Koppeleinrichtung (145; 1450) an wenigstens einen Resonator ($SAW_1$, $SAW_N$) ausgibt und ein Ausgangssignal (as') des wenigstens einen Resonators ($SAW_1$, $SAW_N$) empfängt und an wenigstens einen Eingang (E1, E2) der Sechs-Tor-Schaltung (110) und/oder an einen der Sechs-Tor-Schaltung (110) zugeordneten Leistungsteiler (150) ausgibt.

**20.** Verfahren nach einem der Ansprüche 13 bis 19, wobei das Messsystem (100; 100a; 100b; 100c; 100d) einen ersten Schalter (SW1) aufweist, wobei das Messsystem (100; 100a; 100b; 100c; 100d) mittels des ersten Schalters (SW1) ein an seinem Eingang (SW1a) zugeführtes Eingangssignal, insbesondere ein Referenzsignal (rs) oder ein Anregungssignal (as) für einen Resonator, wahlweise an eine bzw. die Koppeleinrichtung (145; 1450) ausgibt oder an einen Eingang (E1, E2) der Sechs-Tor-Schaltung (110) und/oder einen Eingang eines der Sechs-Tor-Schaltung (110) zugeordneten Leistungsteilers (150), wobei insbesondere das Messsystem (100; 100a; 100b; 100c; 100d) einen zweiten Schalter (SW2) aufweist, wobei das Messsystem (100; 100a; 100b; 100c; 100d) mittels des zweiten Schalters (SW2) den zweiten Eingang (E2) der Sechs-Tor-Schaltung (110) wahlweise mit einer ein bzw. das Referenzsignal (rs) bereitstellenden Quelle (140) oder einem Ausgang (120b; 1200b) der Verzögerungsleitung (120; 1200) verbindet, wobei insbesondere die Verzögerungsleitung (1200) wenigstens zwei wahlweise einstellbare Verzögerungsleitungslängen aufweist, und wobei das Messsystem (100; 100a; 100b; 100c; 100d) in einer dritten Betriebsart eine erste Verzögerungsleitungslänge der Verzögerungsleitung (1200) einstellt, und in einer vierten Betriebsart eine zweite Verzögerungsleitungslänge der Verzögerungsleitung (1200) einstellt, wobei die zweite Verzögerungsleitungslänge verschieden ist von der ersten Verzögerungsleitungslänge, wobei insbesondere die zweite Verzögerungsleitungslänge größer ist als die erste Verzögerungsleitungslänge, wobei insbesondere das elektrische Signal (s1) und/oder das Referenzsignal (rs) in wenigstens einem ISM-Frequenzband liegt, besondere in einem Frequenzbereich zwischen etwa 2400 MHz und etwa 2500 MHz.

21. Verfahren nach einem der Ansprüche 13 bis 20, wobei das Messsystem (100; 100a; 100b; 100c; 100d) zumindest zeitweise wenigstens einen Datenrahmen, insbesondere einen beacon-Datenrahmen gemäß der IEEE 802.11 Protokollfamilie, aussendet, insbesondere um anderen gegebenenfalls in Funkreichweite befindlichen Systemen das Vorhandensein eines Senders zu suggerieren, der insbesondere gemäß der IEEE 802.11 Protokollfamilie und/oder gemäß wenigstens einer der folgenden Protokolle arbeitet: IEEE 802.15.4, insbesondere ZigBee und/oder Bluetooth, wobei insbesondere das Messsystem (100; 100a; 100b; 100c; 100d) dann wenigstens einen Datenrahmen, insbesondere einen beacon-Datenrahmen gemäß der IEEE 802.11 Protokollfamilie, aussendet, wenn zuvor in der zweiten Betriebsart festgestellt worden ist, dass ein Störsignal (is) mit einer einen Schwellwert überschreitenden Signalleistung vorliegt.

22. Verfahren nach einem der Ansprüche 13 bis 21, wobei das Messsystem (100; 100a; 100b; 100c; 100d) zumindest zeitweise ein Linearisierungssignal (ls) einerseits direkt dem ersten Eingangsanschluss (E1) der Sechs-Tor-Schaltung (110) und andererseits über die Verzögerungsleitung (120; 1200) dem zweiten Eingangsanschluss (E2) der Sechs-Tor-Schaltung (110) zuführt.

## Claims

1. An electrical measuring system (100; 100a; 100b; 100c; 100d), comprising a six-port circuit (110), a delay line (120), and an arithmetic unit (130), wherein, in a first operating mode, an electrical signal (s1) is, on the one hand, supplyable directly to a first input terminal (E1) and, on the other hand, supplyable via said delay line (120) to a second input terminal (E2) of said six-port circuit (110), and wherein said arithmetic unit (130) is configured to determine a frequency of the signal (s1) depending on at least one output signal (b3, b4, b5, b6) of said six-port circuit (110), **characterized in that** said measuring system (100; 100a; 100b; 100c; 100d) is, in a second operating mode, configured to supply no signal to said first input terminal (E1) of said six-port circuit (110) and to supply a predetermined reference signal (rs) to said second input terminal (E2) of said six-port circuit (110), wherein said measuring system (100; 100a; 100b; 100c; 100d) is, in the second operating mode, further configured to determine the presence of an interference signal (is), in particular in the region of said first input terminal (E1), depending on at least one output signal (b3, b4, b5, b6) of said six-port circuit (110).

2. The measuring system (100; 100a; 100b; 100c; 100d) (130) according to claim 1, wherein said arithmetic unit (130) is configured, in the second operating mode, to evaluate at least two output signals (b3, b4) received at different output terminals (A1, A2) of said six-port circuit (110) and/or signals ($B_3$, $B_4$) derived therefrom and to determine, depending on the evaluation, the presence of an interference signal (is), wherein, in particular, said arithmetic unit (130) is configured, in the second operating mode, to evaluate four output signals (b3, b4, b5, b6) received at different output terminals (A1, A2, A3, A4) of said six-port circuit (110) and/or signals ($B_3$, $B_4$, $B_5$, $B_6$) derived therefrom and to determine, depending on the evaluation, the presence of an interference signal (is).

3. The measuring system (100; 100a; 100b; 100c; 100d) according to any one of the preceding claims, wherein said arithmetic unit (130) is configured to detect, essentially simultaneously. at least two output signals (b3, b4) and/or signals ($B_3$, $B_4$) derived therefrom.

4. The measuring system (100; 100a; 100b; 100c; 100d) according to any one of the preceding claims, wherein said measuring system (100; 100a; 100b; 100c; 100d) is configured to enter the second operating mode in order to investigate the presence of possible interfering signals, thereby obtaining information characterizing an interference signal, and wherein said measuring system (100; 100a; 100b; 100c; 100d) is configured to switch to the first operating mode after the second operating mode depending on the information characterizing an interference signal in order to determine a frequency of the electrical signal (s1).

5. The measuring system (100; 100a; 100b; 100c; 100d) according to any one of the preceding claims, wherein said measuring system (100; 100a; 100b; 100c; 100d) comprises at least one resonator ($SAW_1$, $SAW_N$) configured to provide the electrical signal (s1), wherein the at least one resonator ($SAW_1$, $SAW_N$) is, in particular, configured as surface acoustic wave resonator.

6. The measuring system (100, 100a, 100b, 100c, 100d) according to any one of the preceding claims, wherein said measuring system (100, 100a, 100b, 100c, 100d) comprises at least one signal generator (140) configured to provide the reference signal (rs) and/or an excitation signal (as) to one of the at least one resonator ($SAW_1$, $SAW_N$).

7. The measuring system (100; 100a; 100b; 100c; 100d) according to any one of the preceding claims, wherein said measuring system (100, 100a, 100b, 100c, 100d) comprises a coupling device (145) configured to output an excitation signal (as) to at least one resonator ($SAW_1$, $SAW_N$) and to receive an output signal (as') of the at least one resonator ($SAW_1$, $SAW_N$) and to output the output signal (as') to at least one input (El, E2) of said six-port circuit (110) and/or to a power divider (150) assigned to said six-port circuit (110).

8. The measuring system (100; 100a; 100b; 100c; 100d) according to any one of the preceding claims, wherein said measuring system (100, 100a, 100b, 100c, 100d) comprises a first switch (SW1) configured to output an input signal supplied to an input (SW1a) of said first switch (SW1) selectively at a first output terminal or at a second output terminal of an output (SW1b) of said first switch (SW1), wherein, in particular, the input of said first switch (SW1) is connectable to one of the at least one signal generator (140), wherein the first output terminal of said first switch (SW1) is connectable to one of the at least one coupling device (145; 1450), wherein the second output terminal of said first switch (SW1) is connectable to at least one input (E1, E2) of said six-port circuit (110) and/or an input of a power divider (150) assigned to said six-port circuit (110).

9. The measuring system (100, 100a, 100b, 100c, 100d) according to any one of the preceding claims, wherein said measuring system (100; 100a; 100b; 100c; 100d) comprises a second switch (SW2) configured to connect the second input (E2) of said six-port circuit (110) selectively to a source (140) providing one of the at least one reference signal (rs) or to an output (120b; 1200b) of said delay line (120; 1200).

10. The measuring system (100; 100a; 100b; 100c; 100d) according to any one of the preceding claims, wherein said delay line (1200) has at least two selectable delay line lengths.

11. The measuring system (100; 100a; 100b; 100c; 100d) according to claim 10, wherein said measuring system (100, 100a, 100b, 100c, 100d) is configured, in a third operating mode, to set a first delay line length of said delay line (1200); and, in a fourth operating mode, to set a second delay line length of said delay line (1200), the second delay line length being different from the first delay line length, in particular the second delay line length being greater than the first delay line length.

12. The measuring system (100; 100a; 100b; 100c; 100d) according to any one of the preceding claims, wherein said measuring system (100, 100a, 100b, 100c, 100d) is configured to supply, at least temporarily, a linearization signal (ls), on the one hand, directly to the first input terminal (E1) of said six-port circuit (110) and, on the other hand, via the delay line (120) to the second input terminal (E2) of said six-port circuit (110).

13. A method for operating an electrical measuring system (100; 100a; 100b; 100c; 100d) comprising a six-port circuit (110), a delay line (120), and an arithmetic unit (130), wherein, in a first operating mode, an electrical signal (100; s1) is supplied, on the one hand, directly to a first input terminal (E1) and, on the other hand, via said delay line (120) to a second input terminal (E2) of said six-port circuit (110), and wherein said arithmetic unit (130) determines a frequency of the signal (s1) depending on at least one output signal (b3, b4, b5, b6) of said six-port circuit (110), **characterized in that** the measuring system (100), in a second operating mode, supplies no signal to said first input terminal (E1) of said six-port circuit (110) and supplies a predetermined reference signal (rs) to said second input terminal (E2) of said six-port circuit (110), wherein said measuring system (100) further determines, in the second operating mode, the presence of an interference signal (is), in particular in the region of said first input terminal (E1), depending on at least one output signal (b3, b4, b5, b6) of said six-port circuit (110).

**14.** The method of claim 13, wherein, in the second operating mode, said arithmetic unit (130) evaluates at least two output signals (b3, b4) received at different output terminals (A1, A2) of said six-port circuit (110) and/or signals ($B_3$, $B_4$) derived therefrom and determines, depending on the evaluation, the presence of an interference signal (is), wherein, in the second operating mode, said arithmetic unit (130) evaluates, in particular, four output signals (b3, b4, b5, b6) received at different output terminals (AI, A2, A3, A4) of said six-port circuit (110) and/or signals (B3, B4, B5, B6) derived therefrom and determines the presence of an interference signal (is) based on the evaluation.

**15.** The method according to any one of claims 13 to 14, wherein said arithmetic unit (130) detects, substantially simultaneously, at least two output signals (b3, b4) and/or signals ($B_3$, $B_4$) derived therefrom.

**16.** The method according to any one of claims 13 to 15, wherein said measuring system (100; 100a; 100b; 100c; 100d) enters the second operating mode in order to investigate the presence of possible interference signals, thereby obtaining information characterizing an interference signal, and wherein said measuring system (100; 100a; 100b; 100c; 100d) switches to the first operating mode after the second operating mode depending on the information characterizing an interference signal in order to determine a frequency of the electrical signal (s1).

**17.** The method according to claim 16, wherein said measuring system (100; 100a; 100b; 100c; 100d) determines, depending on the information characterizing an interference signal, a waiting period before a switch from the second operating mode to the first operating mode is performed.

**18.** The method according to any one of claims 13 to 17, wherein said measuring system (100; 100a; 100b; 100c; 100d) comprises at least one signal generator (140) and provides, by means of said signal generator (140), one of the at least one reference signal (rs), and/or an excitation signal (as) to a resonator (SAW$_1$, SAW$_N$).

**19.** The method according to any one of claims 13 to 18, wherein said measuring system (100, 100a, 100b, 100c, 100d) comprises a coupling device (455, 1450), wherein said measuring system (100, 100a, 100b, 100c, 100d), by means of said coupling device (145; 1450), outputs an excitation signal (as) to at least one resonator (SAW$_1$, SAW$_N$) and receives an output signal (as') of the at least one resonator (SAW$_1$, SAW$_N$) and outputs the output signal (as') to at least one input (E1, E2) of said six-port circuit (110) and/or to a power divider (150) assigned to said six-port circuit (110).

**20.** The method according to any one of claims 13 to 19, wherein said measuring system (100; 100a; 100b; 100c; 100d) comprises a first switch (SW1), wherein said measuring system (100; 100a; 100b; 100c; 100d), by means of said first switch (SW1), outputs an input signal, in particular a reference signal (rs) or an excitation signal (as) for a resonator, selectively to one of the at least one coupling device (145; 1450) and/or to an input (E1, E2) of said six-port circuit (110) and/or to an input of a power divider (150) assigned to said six-port circuit (110), wherein, in particular, said measuring system (100; 100a; 100b; 100c; 100d) comprises a second switch (SW2), wherein said measuring system (100; 100a; 100b; 100c; 100d), by means of said second switch (SW2), selectively connects the second input (E2) of said six-port circuit (110) to a source (140) providing one of the at least one reference signal (rs) or to an output (120b, 1200b) of said delay line (120, 1200), said delay line (1200), in particular, having at least two selectable delay line lengths, and wherein said measuring system (100; 100a; 100b; 100c; 100d), in a third operating mode, sets a first delay line length of said delay line (1200), and, in a fourth operating mode, sets a second delay line length of said delay line (1200), the second delay line length being different from the first delay line length, in particular the second delay line length being greater than the first delay line length, wherein, in particular, the electrical signal (s1) and/or the reference signal (rs) is in at least one ISM frequency band, in particular in a frequency range between about 2400 MHz and about 2500 MHz.

**21.** The method according to any one of claims 13 to 20, wherein said measuring system (100; 100a; 110b; 100c; 100d), at least temporarily, sends out at least one data frame, in particular a beacon data frame according to the IEEE 802.11 protocol family, in particular to advertise, to other systems possibly within radio range, the presence of a transmitter operating, in particular, according to the IEEE 802.11 protocol family and/or according to at least one of the following protocols: IEEE 802.15.4, in particular ZigBee and/or Bluetooth, wherein, in particular, said measuring system (100; 100a; 100b; 100c; 100d) sends out at least one data frame, in particular a beacon data frame according to the IEEE 802.11 protocol family, when it has previously been determined in the second operating mode that an interference signal (is) having a signal power exceeding a threshold value is present.

**22.** The method according to any one of claims 13 to 21, wherein said measuring system (100; 100a; 100b; 100c; 100d), at least temporarily, supplies a linearization signal (ls), on the one hand, directly to said first input terminal (E1) of said six-port circuit (110) and, on the other hand, via said delay line (120; 1200) to said second input terminal (E2) of said six-port circuit (110) .

**Revendications**

1. Système de mesure électrique (100; 100a; 100b; 100c; 100d) comportant un circuit à six portes (110), une ligne de retard (120) et une unité de calcul (130), dans lequel, dans un premier mode de fonctionnement, un signal électrique (s1) peut d'une part être fourni directement à une première borne d'entrée (E1) et d'autre part à une deuxième borne d'entrée (E2) du circuit à six portes (110) via la ligne de retard (120), et dans lequel l'unité de calcul (130) est conçue pour déterminer une fréquence du signal (s1) en fonction d'au moins un signal de sortie (b3, b4, b5, b6) du circuit à six portes (110), **caractérisé en ce que** le système de mesure (100; 100a; 100b; 100c; 100d) est conçu pour, dans un deuxième mode de fonctionnement, ne pas fournir de signal à la première borne d'entrée (E1) du circuit à six portes (110) et fournir un signal de référence prédéterminable (rs) à la deuxième borne d'entrée (E2) du circuit à six portes (110), dans lequel le système de mesure (100; 100a; 100b; 100c; 100d) est en outre conçu pour, dans le deuxième mode de fonctionnement, se fermer en fonction d'au moins un signal de sortie (b3, b4, b5, b6) du circuit à six portes (110) en présence d'un signal perturbateur (is), en particulier dans la zone de la première borne d'entrée (E1).

2. Système de mesure (100; 100a; 100b; 100c; 100d) selon la revendication 1, dans lequel l'unité de calcul (130) est conçue pour, dans le deuxième mode de fonctionnement, évaluer au moins deux signaux de sortie reçus au niveau de bornes de sortie différentes (A1, A2) du circuit à six portes (110) et/ou des signaux $(B_3, B_4)$ qui en proviennent et se fermer en cas d'évaluation d'un signal perturbateur (is), dans lequel l'unité de calcul (130) est en outre conçue pour, dans le deuxième mode de fonctionnement, évaluer quatre signaux de sortie (b3, b4, b5, b6) reçus à différentes bornes de sortie (A1, A2, A3, A4) du circuit à six portes (110) et/ou signaux $(B_3, B_4, B_5, B_6)$ qui en proviennent, et se ferme en cas d'évaluation d'un signal perturbateur (is).

3. Système de mesure (100; 100a; 100b; 100c; 100d) selon l'une des revendications précédentes, dans lequel l'unité de calcul (130) est conçue pour capteur au moins deux signaux de sortie (b3, b4) et/ou signaux $(B_3, B_4)$ qui en proviennent sensiblement simultanément.

4. Système de mesure (100; 100a; 100b; 100c; 100d) selon l'une quelconque des revendications précédentes, dans lequel le système de mesure (100; 100a; 100b; 100c; 100d) est conçu pour adopter le deuxième mode de fonctionnement afin d'étudier la présence de possibles signaux perturbateurs, en obtenant ainsi des informations caractéristiques d'un signal perturbateur, et dans lequel le système de mesure (100; 100a; 100b; 100c; 100d) est conçu pour passer au premier mode de fonctionnement après le deuxième mode de fonctionnement, en fonction des informations caractéristiques d'un signal perturbateur, pour déterminer une fréquence du signal électrique (s1).

5. Système de mesure (100; 100a; 100b; 100c; 100d) selon l'une quelconque des revendications précédentes, dans lequel le système de mesure (100; 100a; 100b; 100c; 100d) comporte au moins un résonateur $(SAW_1, SAW_N)$ qui est conçu pour être pour fournir un signal électrique (s1), dans lequel en particulier le au moins un résonateur $(SAW_1, SAW_N)$ est conçu sous la forme d'un résonateur acoustique d'ondes de surface.

6. Système de mesure (100; 100a; 100b; 100c; 100d) selon l'une quelconque des revendications précédentes, dans lequel le système de mesure (100; 100a; 100b; 100c; 100d) comporte au moins un générateur de signal (140) qui est conçu pour fournir le signal de référence (rs) et/ou un signal d'excitation (as) pour un ou le résonateur $(SAW_1, SAW_N)$.

7. Système de mesure (100; 100a; 100b; 100c; 100d) selon l'une quelconque des revendications précédentes, dans lequel le système de mesure (100; 100a; 100b; 100c; 100d) comporte un dispositif de couplage (145; 1450) qui est conçu pour émettre un signal d'excitation (as) au niveau d'au moins un résonateur $(SAW_1, SAW_N)$ et recevoir un signal de sortie (as') au niveau du au moins un résonateur $(SAW_1, SAW_N)$ et d'au moins une entrée (E1, E2) du circuit à six portes (110) et/ou d'un diviseur de puissance (150) associé au circuit à six portes (110).

8. Système de mesure (100; 100a; 100b; 100c; 100d) selon l'une quelconque des revendications précédentes, dans lequel le système de mesure (100; 100a; 100b; 100c; 100d) comporte un premier commutateur (SW1) qui est conçu pour émettre un signal d'entrée guidé vers son entrée (SW1a) au choix vers une première borne de sortie de sa sortie (SW1b) ou sur une deuxième borne de sortie de sa sortie (SW1b), dans lequel en particulier l'entrée du premier commutateur (SW1) peut être connectée avec un ou le générateur de signal (140), dans lequel la première borne de sortie du premier commutateur (SW1) peut être connecté avec un ou le dispositif de couplage (145; 1450), dans lequel la deuxième borne de sortie du premier commutateur (SW1) peut être connectée avec au moins une entrée (E1, E2) du circuit à six portes (110) et/ou une entrée du diviseur de puissance (150) associé au circuit à six portes (110).

9. Système de mesure (100; 100a; 100b; 100c; 100d) selon l'une quelconque des revendications précédentes, dans lequel le système de mesure (100; 100a; 100b; 100c; 100d) comprend un second commutateur (SW2) qui est conçu pour connecter la deuxième entrée (E2) du circuit à six portes (110) au choix à une source (140) fournissant un ou le signal de référence (rs) ou une sortie (120b; 1200b) de la ligne de retard (120; 1200).

10. Système de mesure (100; 100a; 100b; 100c; 100d) selon l'une quelconque des revendications précédentes, dans lequel la ligne de retard (1200) présente au moins deux longueurs de ligne de retard pouvant être réglées au choix.

11. Système de mesure (100; 100a; 100b; 100c; 100d) selon la revendication 10, dans lequel le système de mesure (100; 100a; 100b; 100c; 100d) est conçu pour, dans un troisième mode de fonctionnement, régler une première longueur de ligne de retard de la ligne de retard (1200); et dans un quatrième mode de fonctionnement, régler une seconde longueur de ligne de retard de la ligne de retard (1200), dans lequel la seconde longueur de ligne de retard est différente de la première longueur de ligne de retard, dans lequel en particulier la seconde longueur de ligne de retard est supérieure à la première longueur de ligne de retard.

12. Système de mesure (100; 100a; 100b; 100c; 100d) selon l'une quelconque des revendications précédentes, dans lequel le système de mesure (100; 100a; 100b; 100c; 100d) est conçu pour, au moins parfois, fournir un signal de linéarisation (1s) directement à la première borne d'entrée (El) du circuit à six portes (110), et d'autre part via la ligne de retard (120) de la deuxième borne d'entrée (E2) du circuit à six portes (110).

13. Procédé de fonctionnement d'un système de mesure électrique (100; 100a; 100b; 100c; 100d) comportant un circuit à six portes (110), une ligne de retard (120) et une unité de calcul (130), dans lequel, dans un premier mode de fonctionnement, un signal électrique (s1) peut d'une part être fourni directement à une première borne d'entrée (E1) et d'autre part à une deuxième borne d'entrée (E2) du circuit à six portes (110) via la ligne de retard (120), et dans lequel l'unité de calcul (130) est conçue pour déterminer une fréquence du signal (s1) en fonction d'au moins un signal de sortie (b3, b4, b5, b6) du circuit à six portes (110), **caractérisé en ce que** le système de mesure (100; 100a; 100b; 100c; 100d) est conçu pour, dans un deuxième mode de fonctionnement, ne pas fournir de signal à la première borne d'entrée (E1) du circuit à six portes (110) et fournir un signal de référence prédéterminable (rs) à la deuxième borne d'entrée (E2) du circuit à six portes (110), dans lequel le système de mesure (100; 100a; 100b; 100c; 100d) est en outre conçu pour, dans le deuxième mode de fonctionnement, se fermer en fonction d'au moins un signal de sortie (b3, b4, b5, b6) du circuit à six portes (110) en présence d'un signal perturbateur (is), en particulier dans la zone de la première borne d'entrée (E1).

14. Procédé selon la revendication 13, dans lequel l'unité de calcul (130), dans le deuxième mode de fonctionnement, évalue au moins deux signaux de sortie reçus au niveau de bornes de sortie différentes (A1, A2) du circuit à six portes (110) et/ou des signaux ($B_3$, $B_4$) qui en proviennent et se ferme en cas d'évaluation d'un signal perturbateur (is), dans lequel l'unité de calcul (130), en particulier dans le deuxième mode de fonctionnement, évalue quatre signaux de sortie (b3, b4, b5, b6) reçus à différentes bornes de sortie (A1, A2, A3, A4) du circuit à six portes (110) et/ou signaux ($B_3$, $B_4$, $B_5$, $B_6$) qui en proviennent, et se ferme en cas d'évaluation d'un signal perturbateur (is).

15. Procédé selon l'une quelconque des revendications 13 à 14, dans lequel l'unité de calcul (130) capte au moins deux signaux de sortie (b3, b4) et/ou signaux ($B_3$, $B_4$) qui en proviennent sensiblement simultanément.

16. Procédé selon l'une quelconque des revendications 13 à 15, dans lequel le système de mesure (100; 100a; 100b; 100c; 100d) adopte le deuxième mode de fonctionnement afin d'étudier la présence de possibles signaux perturbateurs, en obtenant ainsi des informations caractéristiques d'un signal perturbateur, et dans lequel le système de mesure (100; 100a; 100b; 100c; 100d) passe au premier mode de fonctionnement après le deuxième mode de fonctionnement, en fonction des informations caractéristiques d'un signal perturbateur, pour déterminer une fréquence du signal électrique (s1).

17. Procédé selon la revendication 16, dans lequel le système de mesure (100; 100a; 100b; 100c; 100d) détermine un temps d'attente sur la base des informations caractéristiques d'un signal perturbateur, qui est attendu avant de faire un choix de passer du deuxième mode de fonctionnement au premier mode.

**18.** Procédé selon l'une quelconque des revendications 13 à 17, dans lequel le système de mesure (100; 100a; 100b; 100c; 100d) comporte au moins un générateur de signal (140) et, à l'aide du générateur de signal (140), fournit le signal de référence (rs) et/ou un signal d'excitation (as) pour un résonateur (SAW$_1$, SAW$_N$).

**19.** Procédé selon l'une quelconque des revendications 13 à 18, dans lequel le système de mesure (100; 100a; 100b; 100c; 100d) comporte un dispositif de couplage (145; 1450), dans lequel le système de mesure (100; 100a; 100b; 100c; 100d) émet un signal d'excitation (as) via le dispositif de couplage (145; 1450) au niveau d'au moins un résonateur (SAW$_1$, SAW$_N$) et reçoit un signal de sortie (as') au niveau du au moins un résonateur (SAW$_1$, SAW$_N$) et d'au moins une entrée (E1, E2) du circuit à six portes (110) et/ou d'un diviseur de puissance (150) associé au circuit à six portes (110).

**20.** Procédé selon l'une des revendications 13 à 19, dans lequel le système de mesure (100; 100a; 100b; 100c; 100d) comporte un premier commutateur (SW1), dans lequel le système de mesure (100; 100a; 100b; 100c; 100d), via le premier commutateur (SW1), émet un signal d'entrée guidé vers son entrée (SW1a), en particulier un signal de référence (rs) ou un signal d'excitation (as) pour un résonateur, au choix vers un ou le dispositif de couplage (145; 1450) ou vers une entrée (EI, E2) du circuit à six portes (110) et/ou une entrée d'un diviseur de puissance (150) associé au circuit à six portes (110), dans lequel en particulier le système de mesure (100; 100a; 100b; 100c; 100d) comporte un second commutateur (SW2), dans lequel le système de mesure (100; 100a; 100b; 100c; 100d), via le second commutateur (SW2), connecte la seconde entrée (E2) au choix avec une source (140) fournissant un ou le signal de référence (rs) ou avec une sortie (120b, 1200b) de la ligne de retard (120, 1200), dans lequel en particulier la ligne de retard (1200) présente au moins deux longueurs de ligne de retard réglables au choix, et dans lequel le système de mesure (100; 100a; 100b; 100c; 100d), dans un troisième mode de fonctionnement, règle une première longueur de ligne de retard de la ligne de retard (1200), et règle une seconde longueur de ligne de retard de la ligne de retard (1200) dans un quatrième mode de fonctionnement, dans lequel la seconde longueur de ligne de retard est différente de la première longueur de ligne de retard, dans lequel en particulier la seconde longueur de ligne de retard est supérieure à la première longueur de ligne de retard, dans lequel en particulier le signal électrique (s1) et/ou le signal de référence (rs) se trouve dans au moins une bande de fréquence ISM, en particulier dans une plage de fréquence comprise entre environ 2400 MHz et environ 2500 MHz.

**21.** Procédé selon l'une quelconque des revendications 13 à 20, dans lequel le système de mesure (100; 100a; 100b; 100c; 100d) envoie au moins parfois au moins une trame de données, en particulier une trame de données de balise selon la famille de protocole IEEE 802.11, en particulier pour suggérer à d'autres système se trouvant éventuellement dans les limites de la portée radio la présence d'un émetteur agissant notamment selon la famille de protocole IEEE 802.11 et/ou selon au moins l'un des protocoles suivants : IEEE 802.15.4, en particulier Zig-Bee et/ou Bluetooth, dans lequel en particulier le système de mesure (100; 100a; 100b; 100c, 100d) envoie alors au moins une trame de données, en particulier une trame de données de balise conformément à la famille de protocole IEEE 802.11, s'il a déjà été déterminé dans le deuxième mode de fonctionnement qu'il existe un signal perturbateur (is) avec une puissance de signal dépassant une valeur de seuil.

**22.** Procédé selon l'une quelconque des revendications 13 à 21, dans lequel le système de mesure (100; 100a; 100b; 100c; 100d) fournit au moins parfois un signal de linéarisation (ls) d'une part directement à la première borne d'entrée (EI) du circuit à six portes (110) et d'autre part, via la ligne de retard (120; 1200), à la deuxième borne d'entrée (E2) du circuit à six portes (110) .

Fig. 1

Fig. 2

EP 3 309 561 B1

Fig. 3

Fig. 4

$B_3$ $B_4$ $B_5$ $B_6$

$E_1$ $E_2$ 110

100 112

$\tau_{dl1}$ $\tau_{dl2}$

1202 1200 1204 1206 1200a 1200L

$S_1$ $S_1'$ 1206a

130 150 140 145

$a_s$ $a_s'$

SAWs $SAW_1, SAW_N$

$a_s, a_s'$

**Fig. 5**

EP 3 309 561 B1

Fig. 6A

Fig. 6B

Fig. 6C

EP 3 309 561 B1

**Fig. 7**

1450

140

os

1452a

a2  a1  a3

SAW

a5

a4

as

ls

a8

a9

150

as

as'

as'

asils

a6

a7

1452b

1452c

EP 3 309 561 B1

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013209364 A1